(19) Europäisches Patentamt / European Patent Office / Office européen des brevets

(11) **EP 1 614 329 B1**

(12) **EUROPEAN PATENT SPECIFICATION**

(45) Date of publication and mention
of the grant of the patent:
**24.01.2007 Bulletin 2007/04**

(21) Application number: **04727378.4**

(22) Date of filing: **14.04.2004**

(51) Int Cl.:
**H05K 3/12** (2006.01)

(86) International application number:
**PCT/JP2004/005283**

(87) International publication number:
**WO 2004/093507 (28.10.2004 Gazette 2004/44)**

(54) **DISCHARGING SOLUTION, METHOD FOR PRODUCING PATTERNS AND METHOD FOR PRODUCING AN ELECTRONIC DEVICE USING THE DISCHARGING SOLUTION, AND ELECTRONIC DEVICE**

AUSTRAGLÖSUNG, VERFAHREN ZUR ERZEUGUNG VON MUSTERN SOWIE VERFAHREN ZUR HERSTELLUNG EINES ELEKTRONISCHEN GERÄTES UNTER VERWENDUNG DIESER LÖSUNG, UND ELEKTRONISCHES GERÄT

SOLUTION DE DÉCHARGE, PROCÉDÉ POUR L'OBTENTION DE MOTIFS, PROCÉDÉ DE FABRICATION D'UN DISPOSITIF ÉLECTRONIQUE AU MOYEN DE LA SOLUTION DE DÉCHARGE, ET DISPOSITIF ÉLECTRONIQUE

(84) Designated Contracting States:
**DE FR GB**

(30) Priority: **16.04.2003 JP 2003112055**

(43) Date of publication of application:
**11.01.2006 Bulletin 2006/02**

(73) Proprietor: **MATSUSHITA ELECTRIC INDUSTRIAL CO., LTD.**
**Kadoma-shi, Osaka 571-8501 (JP)**

(72) Inventor: **NAKAGAWA, Tohru**
**Shiga 525-0025 (JP)**

(74) Representative: **Vossius & Partner**
**Siebertstrasse 4**
**81675 München (DE)**

(56) References cited:
**EP-A- 1 139 455**   **US-A1- 2002 041 302**
**US-A1- 2002 151 161**   **US-B1- 6 306 204**

• **PATENT ABSTRACTS OF JAPAN vol. 1998, no. 13, 30 November 1998 (1998-11-30) & JP 10 204350 A (SEIKO EPSON CORP), 4 August 1998 (1998-08-04)**

**Description**

The present invention relates to a discharging solution for forming patterns, a method for producing patterns and a method for producing an electronic device using the solution, and an electronic device produced by the method for producing an electronic device of the present invention.

The discharging solution of the present invention can be used for forming patterns by an inkjet method, for example.

The ink-jet method is used widely for printing characters and images as in an inkjet printer, for example. According to the ink-jet method, ink in a liquid form is discharged from a nozzle to the surface of an object to be printed such as paper, and fixed thereon, whereby printing is performed. Recently, due to the ability to form minute patterns, the ink-jet method is being applied to the production of an electronic device, as well as the printing of characters and images. Specific examples of the electronic device to which the inkjet method is applicable include an electric circuit, wiring and electrodes constituting the electric circuit, a resistor, a capacitor, a semiconductor element, a microlens, a charge-coupled device (CCD), and the like.

A specific example of producing an electronic device by the inkjet method will be shown below. For example, G.G. Rozenberg, Applied Physics, vol. 81 (2002), p. 5249-5251, and "Nikkei Electronics", June 17, 2002, p. 67-78 show examples of forming a circuit pattern made of metal wiring on a printed board by drawing a metal colloid on the printed board using the ink-jet method. In this example, compared with the case where a circuit pattern is formed by photolithography that is a general procedure, a circuit pattern can be formed within a shorter period of time, and the production cost also can be reduced.

Furthermore, examples of forming an electronic device by drawing functional organic molecules, as well as metal, on the surface of a substrate using the ink-jet method also have been reported. Specifically, there are examples of forming a field-effect transistor (see H. Sirringhaus et al., Science, vol. 290 (2000), p. 2123-2126), forming a display using an electroluminescence phenomenon (see J. Bharathan et al., Applied Physics Letters, vol. 72 (1998), p. 2660-2662), forming a microlens array (see T.R. Hebner et al., Applied Physics Letters, Vol. 72 (1998), p. 519-521), and the like.

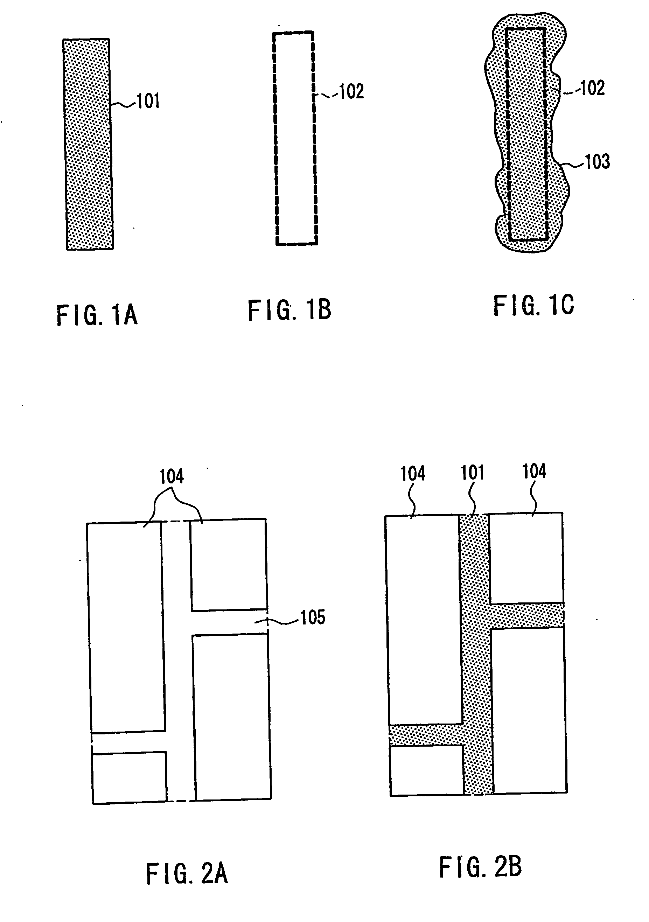

In order to form patterns such as a circuit pattern and an organic molecule pattern on the surface of a base such as a substrate by the ink-jet method, it is necessary that a solution in which metal and organic molecules for forming patterns are dissolved is discharged at a predetermined position on the surface of the base, whereby drawing is performed. According to the ink-jet method, generally, the volume of a solution to be discharged from one nozzle at a given time is about several picoliters. Therefore, it is necessary to discharge a number of liquid droplets so as to form patterns. For example, in the case of forming a pattern 101 in a rectangular shape as shown in FIG. 1A, a number of liquid droplets may be discharged from a nozzle in accordance with the shape of the pattern 101. For example, a solution may be discharged in a region 102 as shown in FIG. 1B, corresponding to the shape of the pattern 101. However, generally, the discharged solution will spread on the surface of the base, and consequently, a pattern with the solution spreading outside of the region 102 as shown in FIG. 1C; for example, is obtained. Thus, it is difficult to form the pattern 101 exactly as shown in FIG. 1A. As the pattern 101 to be formed becomes more minute, the influence of such spreading increases.

In order to suppress a pattern from spreading, conventionally, a pattern (repellent region) with water repellency having a shape complementary to a pattern to be formed is provided previously on the surface of the base. For example, as shown in FIGS. 2A and 2B, a repellent region 104 previously is formed in a shape complementing the pattern 101 to be formed, and a solution may be discharged to a region 105 other than the repellent region 104 (the shape of the pattern 101 to be formed is substantially the same as that of the region 105). The discharged solution is suppressed from spreading inside of the repellent region 104. Therefore, the pattern 101 suppressed from spreading can be formed as shown in FIG. 2B.

For example, JP06(1994)-347637A discloses a method for forming a repellent region made of a silicone resin film on a hydrophilic glass substrate and discharging hydrophilic ink to a region on the substrate other than the repellent region by the ink-jet method. JP2001-284274A discloses a method for forming a pattern of a repellent film to be a repellent region on a substrate, and coating a region without the repellent film with a liquid of an organic silicon compound that is a precursor of a silicon oxide film by the ink-jet method, followed by heat treatment, to form an oxide film pattern. JP2001-274344A discloses a method for producing a memory device using the formation of a pattern having water repellency. In these patent documents, organic molecules having fluoroalkyl chains previously are allowed to adsorb to the entire surface of a base by a vapor phase method or the like; thereafter, a photomask having the same shape as that of a repellent region desired to be formed is allowed to adhere to the base; and the resultant base is irradiated with a UV-ray to form a repellent region. In a region not covered with the photomask, i.e., a region irradiated with a UV-ray, the above-mentioned organic molecules are decomposed to be hydrophilic, and a region covered with the photomask (i.e., a region not irradiated with a UV-ray) becomes water-repellent.

Furthermore, JP07(1995)-335642A discloses a method for forming a thermally grown oxide film region having hydrophilicity and a region terminated with hydrogen having hydrophobicity on the surface of a silicon substrate. According to the method disclosed in JP07(1995)-335642A, the thermally grown oxide film region and the region terminated with hydrogen are formed by the following method. First, a resist pattern is formed on a silicon substrate, the entire surface of which is covered with a thermally grown oxide film, by photolithography. Then, a thermally grown oxide film in a region where the resist is not placed is etched, whereby silicon is exposed. Then, the resist is peeled, and the exposed silicon is terminated with hydrogen.

Furthermore, JP07(1995)-134288A discloses a method for forming a region having water repellency and a region having hydrophilicity on a conductive substrate. The repellent region is formed by printing silicone resin, fluorine resin, dry oil, a resist, or the like, which is water-repellent, on a substrate using silk printing.

According to the above-mentioned conventional method, in order to suppress spreading in the course of pattern formation (i.e., in order to form a pattern more exactly), it is necessary to previously form a repellent region (hereinafter, this may be referred to merely as a "complementary repellent region" in the specification) having a shape complementary to a pattern to be formed. The complementary repellent region is formed by photolithography, silk printing, a UV-irradiation method using a photomask such as a metal mask, or the like. However, these methods are more complicated than the inkjet method, requiring more steps and a larger cost Furthermore, the pattern desired to be formed is not a complementary repellent region, but a pattern having a so-called positive-negative relationship with respect to a complementary repellent region. The complementary repellent region can be omitted unless it is required for other purposes. In order to discharge a solution to a region other than a complementary repellent region after forming the complementary repellent region, thereby performing drawing, it is necessary to hold the position of an ink-jet apparatus in an exact manner with respect to a base. Therefore, there is a demand for realizing a method for forming a pattern (producing a pattern in the case where a pattern itself is a product) more exactly with spreading suppressed by an ink-jet method.

Furthermore, US-B-6 306 204 discloses a discharging solution for forming patterns.

The inventors of the present invention have earnestly studied the chemical and physical properties of a solution to be discharged to the surface of a base by an ink-jet method, and the phenomenon of an interface between the surface of a base and the solution. Consequently, the inventors found that a pattern can be formed (produced) exactly by the ink-jet method.

A discharging solution for forming patterns on a surface of a base of the present invention is defined in claim 1.

The discharging solution of the present invention further may include a second pattern formation material.

Next, a method for producing patterns of the present invention is defined in claim 11.

According to the method for producing patterns of the present invention, the solution further may contain a second pattern formation material, and a solvent contained in the discharged solution may be evaporated to form patterns containing the organic molecules and the second pattern formation material.

Furthermore, the method for producing patterns of the present invention may include evaporating a solvent contained in the discharged solution to form patterns including a first pattern region containing a relatively large amount of the organic molecules and a second pattern region containing a relatively large amount of the second pattern formation material, wherein the patterns are formed so that the first pattern region is present on the base side with respect to the second pattern region.

Next, a method for producing an electronic device of the present invention is defined in claim 22. containing the organic molecules and the second pattern formation material.

Next, an electronic device of the present invention is defined in claim 24.

FIGS. 1A to 1C are schematic views illustrating an exemplary problem caused by a conventional method for forming a pattern.

FIGS. 2A and 2B are schematic views showing an exemplary conventional method for forming a pattern.

FIGS. 3A to 3C are schematic views illustrating an exemplary behavior of a conventional discharging solution discharged to a surface of a base.

FIS. 4A to 4C are schematic views illustrating an exemplary behavior of a discharging solution of the present invention discharged to a surface of a base.

FIGS. 5A to 5C are schematic views illustrating an exemplary behavior of the discharging solution of the present invention discharged to the surface of a base.

FIGS. 6A to 6C are schematic views showing an exemplary reaction between the discharging solution of the present invention and the surface of a base.

FIG. 7 is a schematic view illustrating a contact angle θ formed between the surface of a base and the solution.

FIG. 8 is a schematic view illustrating an exemplary chemical reaction in the discharging solution of the present invention.

FIGS. 9A to 9D are schematic views illustrating an exemplary process in which a pattern is formed of the discharging solution of the present invention.

FIGS. 10A to 10D are schematic views illustrating an exemplary process in which a pattern is formed of the discharging solution of the present invention.

FIG. 11 is a schematic view showing an exemplary method for producing a pattern of the present invention.

FIG. 12 is a schematic view showing an exemplary ink jet apparatus that can be used for the method for producing a pattern of the present invention.

FIGS. 13A and 13B are schematic views showing an exemplary ink-jet head that can be used for the method for producing a pattern of the present-invention.

FIG. 14 is a schematic view showing an exemplary ink-jet head that can be used for the method for producing a pattern of the present invention.

FIGS. 15A and 15B are schematic views showing an exemplary shape of a pattern included in an electronic device of the present invention.

FIG. 16 is a schematic view showing an exemplary shape of a pattern included in a conventional electronic device.

FIG. 17 is a schematic view showing an exemplary shape of a pattern formed in an example.

FIGS. 18A and 18B are schematic views showing an example of a thin film transistor formed in the example.

FIGS. 19A and 19B are schematic views showing an example of a CCD formed in the example.

FIGS. 20A and 20B are schematic views showing an example of an evaluation method of a CCD formed in the example.

Hereinafter, the present invention will be described by way of an embodiment with reference to the drawings. In the following embodiment, like components are denoted with like reference numerals, and a repeated description may be omitted.

First, a discharging solution of the present invention will be described.

The discharging solution of the present invention is used for forming a pattern on the surface of a base. The discharging solution contains organic molecules having fluoroalkyl chains as a first pattern formation material. Furthermore, the surface tension of the discharging solution is 20 dyne/cm (1 dyne/cm=0.001N/m) or more. By discharging such a discharging solution to the surface of a base, a pattern with spreading suppressed can be formed without previously forming the above-mentioned complementary repellent region on the surface of the base. More specifically, a pattern can be formed more exactly.

There is no particular limit to the method for discharging the discharging solution of the present invention to the surface of a base. For example, an ink-jet method may be used. The ink-jet method may be performed using a general ink-jet apparatus (e.g., an ink-jet printer). A specific example of the apparatus will be described later.

In the case of using an ink-jet method as the method for discharging a discharging solution to the surface of a base, the discharging solution of the present invention may be a discharging liquid for forming a pattern on the surface of a base by the ink-jet method, which contains organic molecules having fluoroalkyl chains as a first pattern formation material and has a surface tension of 20 dyne/cm or more.

The principle of forming a pattern in the case of discharging the discharging solution of the present invention to the surface of a base will be described.

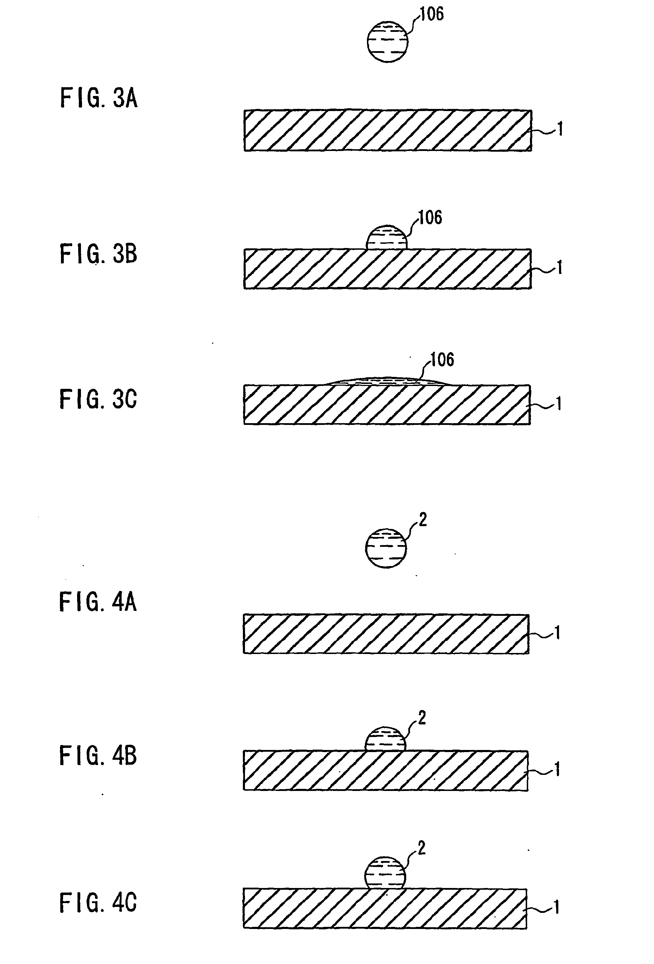

In the case of discharging a general solution 106 such as ink onto the surface of a base 1, the solution 106 generally tends to spread with the passage of time after coming into contact with the surface of the base 1, as shown in FIGS. 3A to 3C. Therefore, as described above, as a pattern to be formed becomes more minute, the influence of spreading increases, making it difficult to form a pattern exactly. Conventionally, in order to suppress spreading, a complementary repellent region is formed. The time sequence in FIGS. 3A to 3C is in the order of FIGS. 3A, 3B, and 3C.

In contrast, in the case of discharging a discharging solution 2 of the present invention to the surface of the base 1, the solution 2 of the present invention tends to shrink somewhat with the passage of time after coming into contact with the surface of the base 1, as shown in FIGS. 4A to 4C. Therefore, if the discharging solution of the present invention is used, the discharged solution 2 can be suppressed from spreading on the surface of the base 1. Thus, for example, by discharging the solution 2 in accordance with the shape of a pattern desired to be formed, a pattern can be formed exactly without previously placing a complementary repellent region on the surface of the base 1. The time sequence in FIGS. 4A to 4C is in the order of FIGS. 4A, 4B, and 4C.

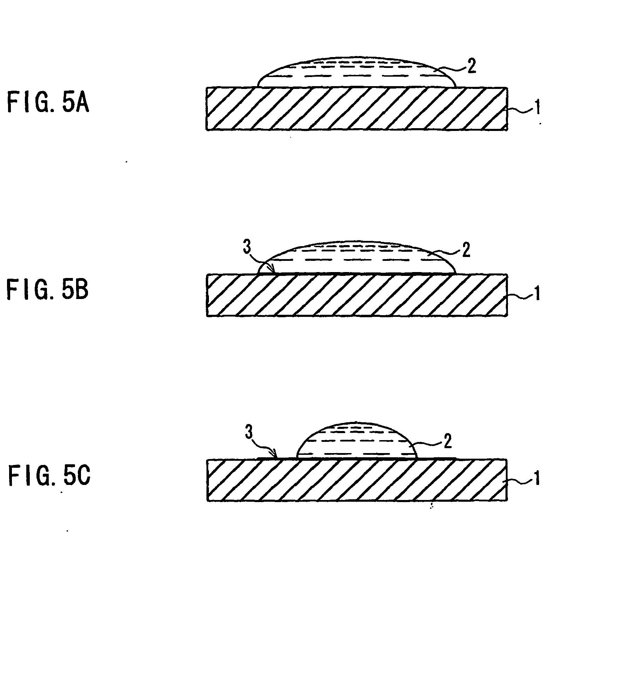

More specifically, the solution 2 of the present invention has the property of wetting the surface of the base 1, for example, in an initial state after being discharged to the surface of the base 1 (FIG. 5A). Therefore, it is possible to discharge the solution 2 at a predetermined position on the surface of the base 1 to perform drawing. However, before a solvent contained in the discharged solution 2 on the base 1 evaporates to disappear, organic molecules having fluoroalkyl chains contained in the solution 2 adsorb to the surface of the base 1, whereby the surface energy of the base 1 in the vicinity of the interface decreases with respect to the solution 2 (FIG. 5B). For example, a region 3 shown in FIG. 5B corresponds to a region where the surface energy decreases due to the contact with the solution 2. When the region 3 is formed, and the surface energy of the region 3 becomes smaller than that of the solution 2, the solution 2 is repelled to shrink on the surface of the base 1 (FIG. 5C).

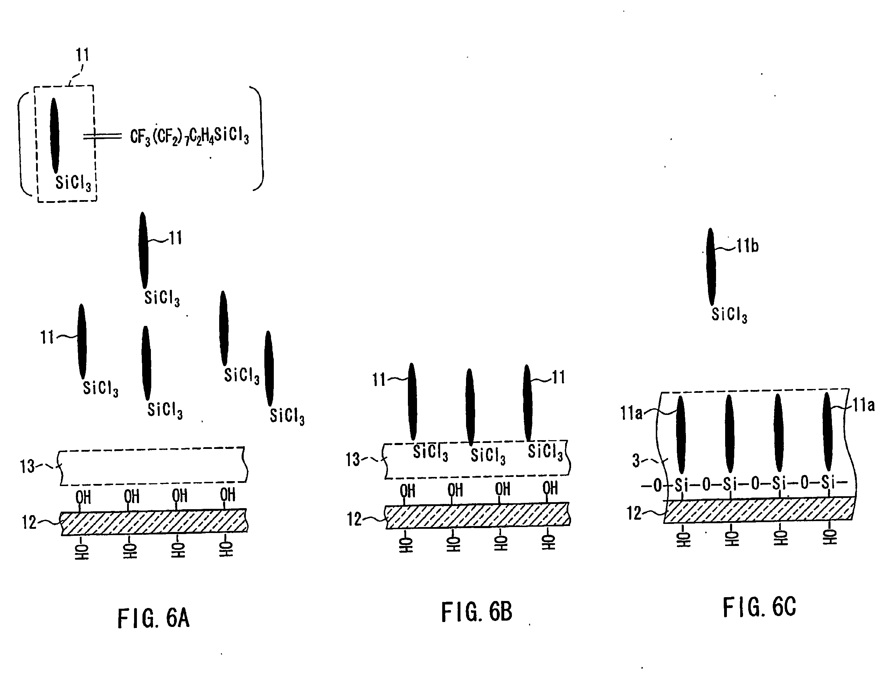

An example of a solution exhibiting such a property includes a liquid in which organic molecules having both nonpolar molecular chains and polar groups are dissolved. A specific example thereof includes a chloroform solution in which 1 vol% of heptadecafluoloethyltrichloro silane ($CF_3(CF_2)_{17}C_2H_4SiCl_3$); hereinafter, this may be referred to as "FCS") is dissolved. In FCS, $CF_3(CF_2)_{17}C_2H_4$- corresponds to a nonpolar molecule chain that contains a fluoroalkyl chain, and a trichlorosilyl group (-$SiCl_3$) corresponds to a polar group. When a solution in which FCS is dissolved is dropped, for example, onto the surface of a thoroughly washed glass substrate, and a change in the shape of the solution is observed, the liquid droplets on the substrate tend to shrink with the passage of time. The proposed mechanism of this phenomenon will be described with reference to FIGS. 6A to 6C.

As shown in FIGS. 6A to 6C, when an FCS chloroform solution is discharged to a glass substrate 12 that is a base (FIG. 6A), FCS molecules 11 dissolved in chloroform that is a solvent adsorb to adsorbed water 13 present on the surface of the glass substrate 12 (FIG. 6B). Herein, the adsorbed water refers to water molecules present in a thickness range of several molecules from the surface of the base, and it is known that such adsorbed water is present on the surface of most bases. The FCS molecules 11 adsorb to the adsorbed water 13 in such a manner that trichlorosilyl groups that are polar groups are aligned on the adsorbed water 13 side, and fluoroalkyl chains that are nonpolar molecular chains are aligned on a side of the adsorbed water 13 opposite to the glass substrate 12. When the FCS molecules 11 adsorb to the adsorbed water 13, the trichlorosilyl groups react with the adsorbed water 13 to become silanol groups (-SiOH). Then, the FCS molecules 11 thermally diffuse on the adsorbed water 13, and are subjected to dehydration polymerization to form siloxane bonds (Si-O). The adsorbed water 13 decreases due to the reaction with the FCS molecules 11 and the dissolution in the chloroform solution. Along with the decrease in the adsorbed water 13, the FCS molecules 11 present on the adsorbed water 13 are dehydrated with hydroxy groups (-OH) present on the surface of the glass substrate 12 to form siloxane bonds. Due to the formation of the siloxane bonds between the FCS molecules 11 and the glass substrate 12, a monomolecular film 3 in which molecular chains of the FCS molecules 11a are aligned vertically on the surface of the glass substrate 12 is formed, as shown in FIG. 6C. The reason for this is considered as follows. The molecular chains of the FCS molecules 11a are chemically stable, and do not react with trichlorosilyl groups of the FCS molecules 11b remaining in the solution, so that the monomolecular film 3 is formed on the surface of the glass substrate 12. As a result of the formation of the monomolecular film 3, the surface energy of the glass substrate 12 becomes about 6 dyne/cm corresponding to the surface energy of $CF_3$ groups contained in the FCS molecules 11. The surface energy of the glass substrate on which the monomolecular film 3 is not formed generally is about 50 dyne/cm or more. Therefore, by discharging the solution containing the FCS molecules 11 to the surface of the glass substrate 12, the surface energy of the glass substrate 12 can be decreased. Along with the decrease in surface energy of the glass substrate 12, the solution discharged to the glass substrate tends to shrink on the glass substrate 12.

The principle of the shrinkage of the discharged solution of the present invention with the passage of time due to the decrease in surface energy on the surface of the base will be described using a Young's equation. In general, the shape of a drop-shaped solution (liquid droplets) present on the surface of a base can be defined by a contact angle θ. The following Equation (1) (Young's equation) holds among the contact angle θ, the surface tension γL of the solution, and the surface energy γS of the base. In Equation (1); γLS is an interface energy between the surface of the base and the solution.

$$\cos\theta = (\gamma S - \gamma LS)/\gamma L \qquad\qquad (1)$$

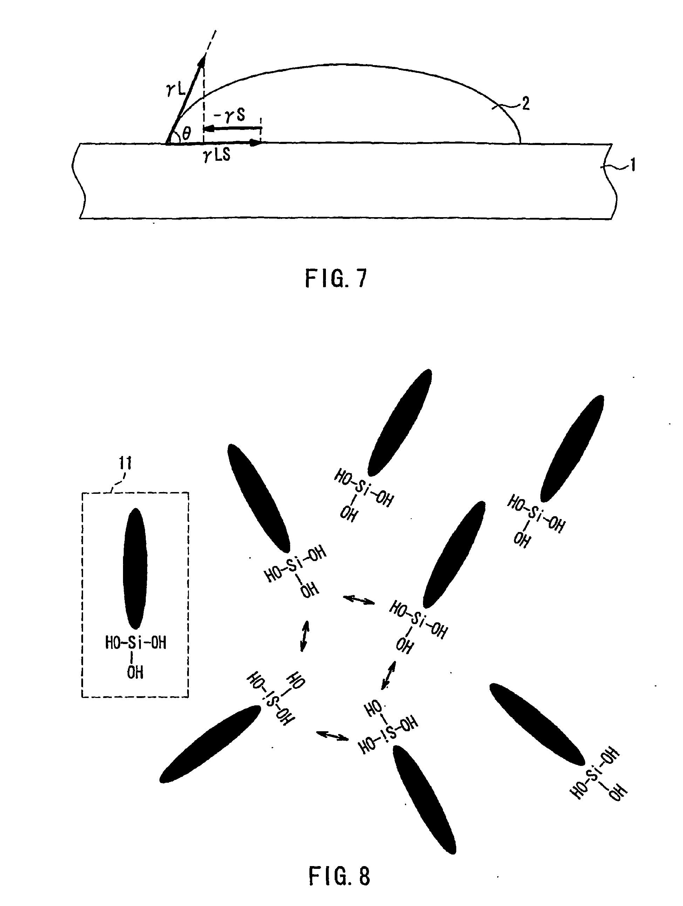

It is generally known that γLS decreases along with the decrease in γS, and in the case where γS decreases, the decrease amount of γLS is smaller than that of γS (see, for example, D.T. Kaelble, J. Adhesion, vol. 2 (1970), p. 66-81). Therefore, when the surface energy γS of the base decreases, the value on the right side in the Equation (1) decreases, and the contact angle θ increases. Thus, the solution discharged to the surface of the base shrinks with the passage of time. The Equation (1) can be displayed in terms of a vector as shown in FIG. 7.

Furthermore, when the discharged solution of the present invention shrinks on the surface of the base, a solvent contained in the solution evaporates simultaneously. Therefore, organic molecules having fluoroalkyl chains contained in the solution are precipitated from the solution. For example, when the chloroform solution of FCS is discharged to the surface of the base, FCS is precipitated from the solution simultaneously with and/or after a delay from the formation of the monomolecular film 3, as shown in FIGS. 6A to 6C. The precipitated FCS molecules are considered to undergo polymerization between molecules to form a polymer as shown in FIG. 8, and are deposited on the monomolecular film 3 shown in FIG. 6C. On the surface of the monomolecular film 3 of FCS, only $CF_3$ groups with a surface energy of about 6 dyne/cm are present, and on the surface of the deposited polymer, $CF_2$ groups and silanol groups (-SiOH) having a surface energy higher than that of $CF_3$ groups are present. Herein, the surface energy of $CF_2$ groups is about 16 dyne/cm, and the surface energy of silanol groups is about 50 dyne/cm to 80 dyne/cm. On the other hand, among the above-mentioned polymers, the number of $CF_3$ and $CF_2$ groups generally is larger than that of SiOH. Thus, when the base is covered with such a polymer, the surface energy of the base decreases. Accordingly, a region where the solution of the present invention is discharged can be made water-repellent. By increasing/decreasing the amount of the FCS molecules in the solution (i.e., increasing/decreasing the concentration of the FCS molecules), the amount of a polymer to be deposited on the monomolecular film can be controlled. The FCS molecules 11 shown in FIG. 8 are those in which trichlorosilyl groups have been changed to silanol groups due to the influence of adsorbed water and the like, and double-sided arrows in FIG. 8 show the silanol groups that react to form siloxane bonds.

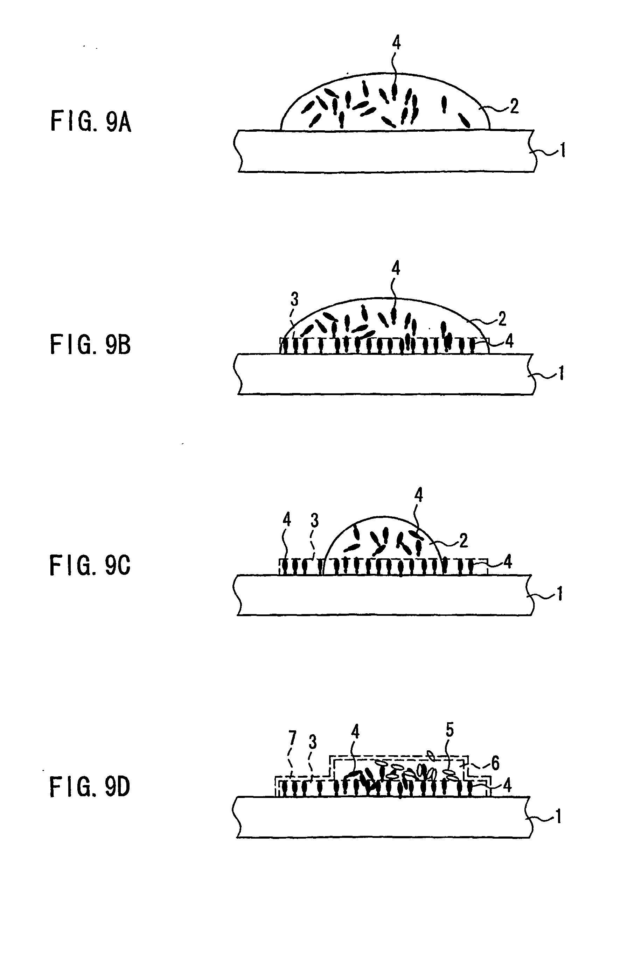

The phenomenon that occurs when the solution 2 of the present invention is discharged to the surface of the base 1 will be described with reference to FIGS. 9A to 9D. FIG. 9A is a schematic view showing the state immediately after the solution 2 containing organic molecules 4 having fluoroalkyl chains is discharged to the surface of the base 1. When a time has elapsed from FIG. 9A, the monomolecular film 3 is formed on the surface of the base 1 (FIG. 9B). When a time further has elapsed, the solution 2 starts shrinking since the surface energy of the monomolecular film 3 is small (FIG. 9C). While the solution 2 shrinks, the solvent contained in the solution 2 also is evaporating. As a result, the monomolecular film 3 made of the organic molecules 4 and a film 6 containing molecules 5 obtained by polymerization between the organic molecules 4 are formed on the surface of the substrate 1 (FIG. 9D). The film 6 is deposited on the monomolecular film 3.

As described above, a region where the monomolecular film 3 and the film 6 are formed have water repellency. Therefore, by discharging the solution 2 of the present invention to the surface of the base 1, a pattern 7 having water repellency (repellent pattern 7) can be formed on the surface of the base 1. In other words, if the discharging solution of the present invention is discharged to the surface of the base, for example, by the ink-jet method, to perform drawing, the pattern having water repellency (repellent pattern) can be formed. At this time, the discharged solution can be suppressed from spreading on the surface of the base. Therefore, the repellent pattern with spreading suppressed can be formed using the discharging solution of the present invention without previously forming a complementary repellent region on the surface of the base. Examples of the repellent pattern that can be formed with the discharging solution of the present invention (that can be produced with the discharging solution of the present invention, in the case where a pattern itself becomes a product) include a master plate for offset printing, a substrate for a biochip (substrate for placing probe molecules to be a sensor in a biochip) such as a DNA chip, and the like.

In addition to the formation of the repellent pattern with the discharging solution of the present invention, the repellent pattern also can be formed by combining the above-mentioned complementary repellent region with the discharging solution of the present invention, the ink-jet method, and the like. Conventionally, photolithography and the like are used for forming the complementary repellent region. However, by using the discharging solution of the present invention, the complementary repellent region can be formed more conveniently.

In the discharging solution of the present invention, organic molecules having fluoroalkyl chains may contain at least one selected from a chlorosilyl group (-SiCl), an alkoxy group (RO-), a mercapto group (-SH), a carboxy group (-COOH), a hydroxy group (-OH), and an amino group. More specifically, the organic molecules may contain, for example, alkoxy groups bonded to Si atoms (-Si-OR). Furthermore, the organic molecules may be those which contain disulfide bonds (-S-S-). Furthermore, the organic molecules may be at least one selected from silazane and dithiol. With the discharging solution containing such organic molecules, a repellent pattern with spreading suppressed can be formed without previously forming a complementary repellent region on the surface of the base. "R" in an alkoxy group represents an alkyl chain. The chlorosilyl group may be a monochlorosilyl group, a dichlorosilyl group, or a trichlorosilyl group. The mercapto group, carboxy group, and hydroxy group respectively may be salts (e.g., $-S \cdot Na^+$): The number of Si in silazane is not particularly limited.

In the case where the organic molecules contain at least one kind of group selected from a carboxy group, a hydroxy group, and an amino group, it is considered that since these groups have polarity, the organic molecules containing such groups are likely to adsorb to the surface of the base having hydrophilicity. Furthermore, in the case where the organic molecules contain chlorosilyl groups, it is considered that the organic molecules react with adsorbed water and active hydrogen on the surface of the base to form siloxane bonds, thereby adsorbing to the surface of the base. This also applies to the case where the organic molecules contain alkoxy groups. In the case where the organic molecules contain mercapto groups, for example, the mercapto groups adsorb to the surfaces of gold and silver.

More specifically, in the discharging solution of the present invention, the organic molecules having fluoroalkyl chains may be those represented by Composition Formula: $CF_3(CF_2)_n C_2H_4 Si\{(O\text{-}CH_2CH_2)_m\text{-}CR^1\}_3$. The organic molecules also may be a hydrolysate of molecules represented by the above Composition Formula. Herein, the hydrolysate of molecules represented by the above Composition Formula refers to the state in which at least one of three functional groups $(O\text{-}CH_2CH_2)_m\text{-}OR^1$ bonded to Si is OH. In the Composition Formula, $R^1$ is a methyl group, an ethyl group, a propyl group, or a butyl group, and $n$ and $m$ are natural numbers of 1 to 10.

More specific examples of the organic molecules contained in the discharging solution of the present invention will be described later

The discharging solution of the present invention further may contain a second pattern formation material. By discharging such a discharging solution to the surface of the base, a pattern with spreading suppressed can be formed without previously forming the above-mentioned complementary repellent region on the surface of the base. In this case, a pattern to be formed contains the second pattern formation material. Furthermore, there is no particular limit to a method for discharging the solution containing the second pattern formation material to the surface of the base. For example, an ink-jet method may be used. The second pattern formation material may be contained in a solution in any form, as long as the solution can be discharged using the ink-jet method. For example, the second pattern formation material may be contained in the discharging solution in a dissolved form or a dispersed form.

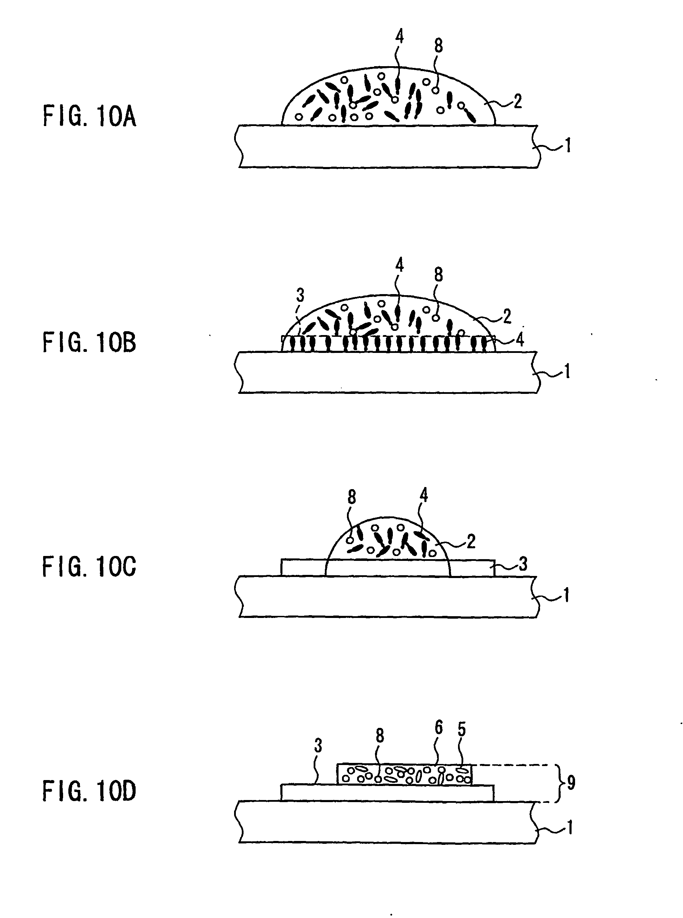

The phenomenon that occurs when the solution 2 of the present invention containing the second pattern formation material is discharged to the surface of the base 1 will be described with reference to FIGS. 10A to 10D. FIG. 10A is a schematic view showing the state immediately after the solution 2 containing the organic molecules 4 having fluoroalkyl chains and the second pattern formation material 8 is discharged to the surface of the base 1. When a time has elapsed from FIG. 10A, a monomolecular film 3 made of the organic molecules 4 is formed on the surface of the base 1 (FIG. 10B) in the same way as in the example shown in FIG. 9B. When a further time has elapsed, the solution 2 starts shrinking since the surface energy of the monomolecular film 3 is small (FIG. 10C). While the solution 2 shrinks, a solvent contained in the solution 2 evaporates simultaneously As a result, the monomolecular film 3 made of the organic molecules 4 and a film 6 containing a second pattern formation material 8 are formed on the surface of the base 1 (FIG. 10D). The film 6 is deposited on the monomolecular film 3, and has a shape substantially similar to that of the monomolecular film 3 due to its formation process. More specifically, by discharging the discharging solution of the present invention containing the second pattern formation material to the surface of the base, a pattern 9 containing the second pattern formation material with spreading suppressed can be formed without previously forming the above-mentioned complementary repellent region on the surface of the base 1. In the p attern 9 formed using the solution containing a second pattern formation material, the second pattern formation material 8 may be mixed with the monomolecular film 3, and the organic molecules 4 may be mixed with the film 6 containing the second pattern formation material 8. Furthermore, the following also may be possible. After the solution is discharged to form a pattern, some after-treatment such as heat treatment is performed, whereby the monomolecular film 3 or the organic molecules 4 may be removed from the pattern 9.

There is no particular limit to the second pattern formation material. The second pattern formation material may be selected arbitrarily in accordance with the p attern 9 desired to be formed.

For example, the second pattern formation material may be a precursor of a metal-oxide dielectric. In this case, by discharging the solution containing a precursor of a metal-oxide dielectric to the surface of the base to perform drawing, evaporating a solvent contained in the solution, and performing predetermined processing (described later) if required, a pattern of the metal-oxide dielectric with spreading suppressed can be formed on the surface of the base. Specific examples of the precursor of the metal-oxide dielectric include at least one material selected from metal alkoxide, metal acetylacetonate, metal carboxylate, and a metal inorganic compound.

For example, the second pattern formation material may be a semiconductor. In this case, by discharging the solution containing a semiconductor to the surface of the base to perform drawing, and evaporating a solvent contained in the solution, a semiconductor pattern with spreading suppressed can be formed on the surface of the base. Furthermore, by selecting a semiconductor material, a semiconductor pattern with an n-type conductivity, a p-type conductivity, or the like can be formed.

For example, the second pattern formation material may be metal. In this case, by discharging a solution containing metal to the surface of the base to perform drawing, and evaporating a solvent contained in the solution, a metal pattern with spreading suppressed can be formed on the surface of the base. As the metal, for example, a metal colloid may be used. Furthermore, predetermined processing such as sintering may be performed if required.

For example, the second pattern formation material may be a polymer. In this case, by discharging a solution containing a polymer to the surface of the base to perform drawing, and evaporating a solvent contained in the solution, a polymer pattern with spreading suppressed can be formed on the surface of the base. There is no particular limit to the kind of a polymer to be used. For example, by using a conductive polymer, a conductive pattern can be formed. Furthermore, for example, by using a semiconductor polymer, a semiconductor pattern can be formed, and by using an insulating polymer, an insulating pattern can be formed. Specific examples of the semiconductor polymer include at least one selected from polyalkylthiophene and poly-9,9'dialkyl-fluorene-co-bithiophene.

In the discharging solution of the present invention, the boiling point of a solvent contained in the solution preferably is 80°C or higher. In the case where the boiling point of the solvent is lower than 80°C, the solvent evaporates in an ink chamber (described later) in an ink-jet apparatus, and the evaporation of the solvent proceeds during discharging, whereby a predetermined amount of the solution may not be discharged to the surface of the base. Furthermore, in the case where the boiling point is lower than 80°C, before the solution discharged to the surface of the base shrinks due to the formation of a monomolecular film, the solution may be dried. In particular, the solution is first dried in the vicinity of a peripheral portion (boundary portion between the region of the base with which the solution contacts and the region of the base with which the solution does not contact) of the discharged solution. Therefore, in the case where the boiling point of the solvent is lower than 80°C, the patterns formed on the base may become those before being shrunk due to the action of the monomolecular film. That is, there is a possibility that it is difficult to form a pattern with the influence of spreading and the like suppressed.

Next, a method for producing a pattern of the present invention will be described.

According to the method for producing a pattern of the present invention, the above-mentioned discharging solution of the present invention (i.e., the solution having a surface tension of 20 dyne/cm or more in which organic molecules having fluoroalkyl chains are dissolved as a first pattern formation material) is discharged to the surface of a base by an ink-jet method to perform drawing, and a solvent contained in the discharged solution is evaporated, whereby a pattern containing organic molecules is formed. The method for producing a pattern of the present invention also may be referred to as a method for forming a pattern. However, assuming that a pattern itself is to be a product, the method will be referred to as a method for producing a pattern. Similarly, in the specification, "a pattern is formed" also is described as "a pattern is produced".

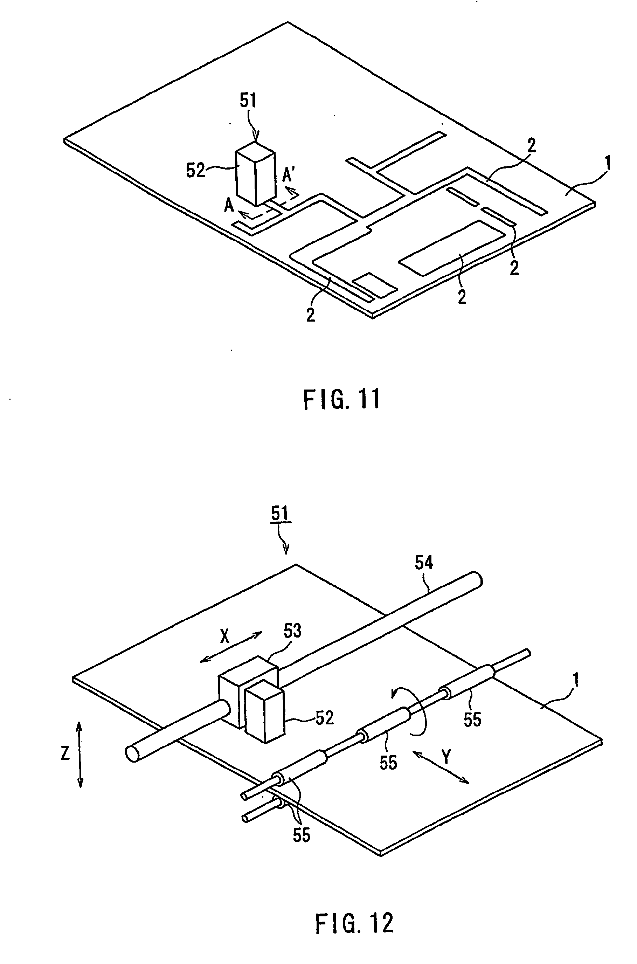

For example, as shown in FIG. 11, a solution 2 may be discharged to the surface of a base 1 using an ink-jet apparatus 51 to perform drawing. A solvent contained in the discharged solution 2 evaporates. In the case where the solution 2 contains the above-mentioned organic molecules that correspond to a first pattern formation material, a repellent pattern 7 is formed on the surface of the base 1 as shown in FIGS. 9A to 9D. Furthermore, in the case where the solution 2 contains the above-mentioned organic molecules that correspond to a first pattern formation material and the above-mentioned second pattern formation material, a pattern 9 containing the above organic molecules and second pattern formation material is formed on the surface of the base 1, as shown in FIGS. 10A to 10D. More specifically, depending upon the method for producing a pattern of the present invention, various patterns such as a repellent pattern, a metal pattern, a semiconductor pattern, an insulator pattern, and the like can be formed while suppressing the influence of spreading without previously forming a complementary repellent region on the surface of the base. In the pattern 9 formed by the method for producing a pattern of the present invention, the second pattern formation material 8 may be mixed with the monomolecular film 3, and the organic molecules 4 may be mixed with the film 6 containing the second pattern formation material 8. Furthermore, the following also may be possible. After the solution is discharged to form a pattern 9, after-treatment such as thermal sintering and heat treatment is performed, whereby the monomolecular film 3 or the organic molecules 4 may be removed from the pattern 9. In this case, a film containing the second pattern formation material 8 can be formed on the surface of the base without interposing the monomolecular film 3. However, the monomolecular film 3 is formed first, so that a film (pattern) containing the second pattern formation material with the influence of spreading and the like suppressed can be formed. Herein, FIGS. 9A to 9D and FIGS. 10A to 10D also are understood to show a change with the passage of time of a cross-section of the solution 2 taken along a line A-A' in FIG. 11.

In the case where the solution to be discharged to the surface of the base by the method for producing a pattern of the present invention contains a second pattern formation material, the method for producing a pattern of the present invention also can be referred to as a method for producing a pattern in which the above-mentioned solution contains a second pattern formation material, a solvent contained in the discharged solution is evaporated, and a pattern containing organic molecules and the second pattern formation material is formed. Such a pattern is, for example, a pattern 9 shown in FIG. 10D.

Furthermore, the method for producing a pattern of the present invention also can be referred to as a method for producing a pattern in which the solution contains a second pattern formation material, a solvent contained in the discharged solution is evaporated, and a pattern including a first pattern region containing a relatively large amount of organic molecules and a second pattern region containing a relatively large amount of the second pattern formation material is formed. In this case, the first pattern region is present on the base side with respect to the second pattern region. Such a first pattern region corresponds to, for example, the monomolecular film 3 shown in FIG. 10D, and a second pattern region corresponds to, for example, the film 6 shown in FIG. 10D. Such a pattern corresponds to, for example, the pattern 9 shown in FIG. 10D.

According to the method for producing a pattern of the present invention, the following may be possible: after a pattern is formed on the surface of a base, the above-mentioned solution further is discharged to perform drawing, using the formed pattern as a base, whereby a pattern is formed. More specifically, according to the method for producing a pattern of the present invention, it also is possible to form a multi-layered pattern. In this case, by changing the shape, kind, and the like of a pattern to be formed in accordance with each layer, various devices such as a semiconductor element, a capacitor, a memory element, a resistor, and the like also can be produced.

The solution used in the method for producing a pattern of the present invention may be, for example, the above-mentioned discharging solution of the present invention. A more specific example of a solution used in the method for producing a pattern of the present invention will be described as a more specific example of the discharging solution of the present invention.

According to the method for producing a pattern of the present invention, for example, the following effects further can be obtained.

In the case where a solution containing metal as a second pattern formation material is discharged to the surface of a base, for example, a circuit pattern can be formed on the surface of the base. Typically, in order to form a circuit pattern on the surface of a base such as a printed substrate, for example, a metal film previously is formed on a substrate, and thereafter, the metal film is formed into a circuit pattern by photolithography. Alternatively, for example, a negative pattern of a circuit is formed on a substrate using a resist film; thereafter, a circuit pattern is formed by plating in a region where a resist is not present; and the resist film is finally removed. According to the method for producing a pattern of the present invention, an ink-jet method is used, so that a conductive circuit pattern can be formed directly on a printed substrate without using a photolithography step that requires man-hours. Therefore, a circuit pattern can be formed in a shorter period of time, and a production cost can be reduced. Furthermore, according to the photolithography method, a photomask (plate) corresponding to a circuit pattern desired to be formed is required. Therefore, in a case requiring a great amount of photomasks as in the production of a small amount of circuit patterns of many kinds, and prototype manufacturing of various circuit patterns, the man-hours and cost will increase. In contrast, the method for producing a pattern of the present invention does not require a photomask. Therefore, a pattern can be produced at a lower cost even in the production of a small amount of circuit patterns of many kinds and the production of a prototype circuit pattern.

In the case of discharging a solution containing a polymer as a second pattern formation material to the surface of a base, for example, a polymer pattern can be formed on the surface of the base. If functional resin is selected as a polymer, a polymer pattern having various functions can be formed on the surface of the base. In this case, depending upon the kind of the functional resin, when the polymer pattern is exposed to a developing agent of a resist and a peeling agent, there is a possibility that the polymer pattern may peel off from the base, and electrical characteristics and the like may be degraded. With such a functional resin, it is difficult to form a pattern in a usual photolithography step. In contrast, the degradation of the characteristics of the functional resin can be suppressed during formation of a pattern, if the method for producing a pattern of the present invention is used-Therefore, a pattern also can be produced even with respect to a material that used to be conventionally difficult to form into a pattern. This also applies to the case where a pattern of organic molecules with low durability with respect to a developing agent of a resist and a peeling agent is formed.

The above-mentioned effects have been described by illustrating a circuit pattern and a polymer pattern. However, the same effects may be obtained in production of other kinds of patterns.

According to the method for producing a pattern of the present invention, the above-mentioned solution is discharged to the surface of the base to perform drawing by an ink-jet method. The ink-jet method may be performed using, for example, an ink-jet apparatus (for example, an ink-jet printer). As an ink-jet apparatus (or an ink-jet printer), a generally used ink-jet apparatus (or ink-jet printer) may be used. For example, an ink-jet apparatus 51 with an ink-jet head 52 as shown in FIG. 11 may be used. Hereinafter, an example of the ink-jet apparatus will be described more specifically.

FIG. 12 is a schematic view showing an example of the ink-jet apparatus 51. For ease of understanding the description, in FIG. 12, a base 1 is shown in addition to the ink-jet apparatus 51. The ink-jet apparatus 51 shown in FIG. 12 has an ink-jet head 52 for discharging a solution 2 to the surface of the base 1. The ink-jet head 52 is connected to an ink carriage 53 oriented in a main scanning direction X. The ink carriage 53 can move along a carriage axis 54, and the ink-jet head 52 can move in the main scanning direction X along with the movement of the ink carriage 53. Furthermore, the ink-jet apparatus 51 shown in FIG. 12 has rollers 55 capable of moving the base 1 in a sub-scanning direction Y orthogonal to the main scanning direction X. By arbitrarily combining the movement of the ink carriage 53 and the movement of the base 1 by the rollers 55, the solution 2 can be discharged to the surface of the base 1 in an arbitrary shape to perform drawing. The ink-jet apparatus 51 further may include a movement portion capable of moving the ink-jet head 52 in the sub-scanning direction Y, in place of the rollers 55, or in addition to the rollers 55. Furthermore, the ink-jet apparatus 1 may include a plurality of scanning directions if required, as well as two scanning directions X and Y For example, in the case where the base 1 has a curved surface, the ink-jet apparatus 1 further includes a movement portion capable of moving the ink-jet head 52 in a Z direction shown in FIG. 12.

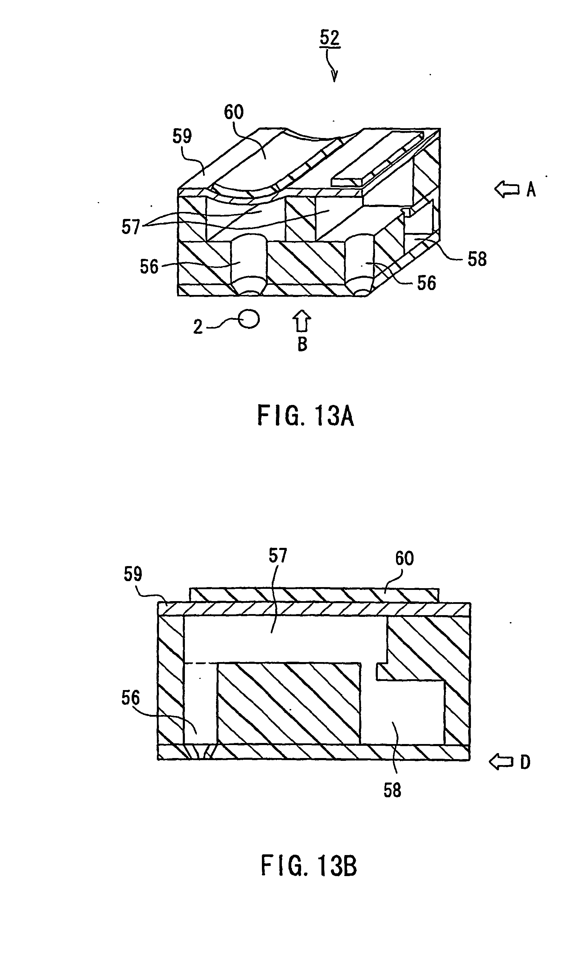

There is no particular limit to a specific configuration of the ink-jet head 52 for discharging the solution 2 to the surface of the base 1. A generally used ink-jet head may be used. For example, the inkjet head 52 having a configuration as shown in FIGS. 13A and 13B may be used. FIG. 13A is a schematic view of a partially cut-away ink-jet head 52 so as to show the internal configuration of the ink-jet head 52. In FIG. 13A, only two nozzle holes 56 are shown; however, the number of the nozzle holes 56 is not limited to two in the actual ink-jet head 52. FIG. 13B is a cross-sectional view showing the ink-jet head 52 in a direction of an arrow A shown in FIG. 13A.

The ink-jet head 52 shown in FIGS. 13A and 13B includes nozzle holes 56 for discharging the solution 2, pressure chambers 57 for outputting the solution 2 to the nozzle holes 56 under pressure (for discharging the solution 2 in the nozzle holes 56 by applying a pressure thereto), and supply portions 58 for supplying the solution 2 to the pressure chambers 57. The supply portions 58 play a role as a solution reservoir. In the case where the solution 2 is discharged from the nozzle holes 56, and the solution 2 in the pressure chambers 57 decreases, the supply portions 58 supply the solution 2 in an amount corresponding to the decrease to the pressure chambers 57. A vibration plate 59 for transmitting a pressure to the solution 2 in the pressure chambers 57 is placed in an upper portion of the pressure chambers 57. Furthermore, piezoelectric elements 60 are placed so as to be in contact with the vibration plate 59. In order to discharge the solution 2, a voltage only needs to be applied to the piezoelectric elements 60. The piezoelectric elements 60 expand due to the application of a voltage, and the vibration plates 59 are deformed, whereby the pressure is transmitted to the pressure chambers 57, and the solution 2 is discharged from the nozzle holes 56. The amount of the solution 2 discharged from the nozzle holes 56 can be controlled by regulating the level of a voltage to be applied to the piezoelectric elements 60 and the application time of the voltage. FIG. 13A shows the state where the piezoelectric element 60 and the vibration plate 59 on the left side are deformed due to the application of a voltage. The vibration plate 59 may be made of, for example, copper, chromium, or the like. For example, copper or the like may be used. The piezoelectric element 60 is not particularly limited, and for example, lead zirconate titanate (PZT) or the like may be used.

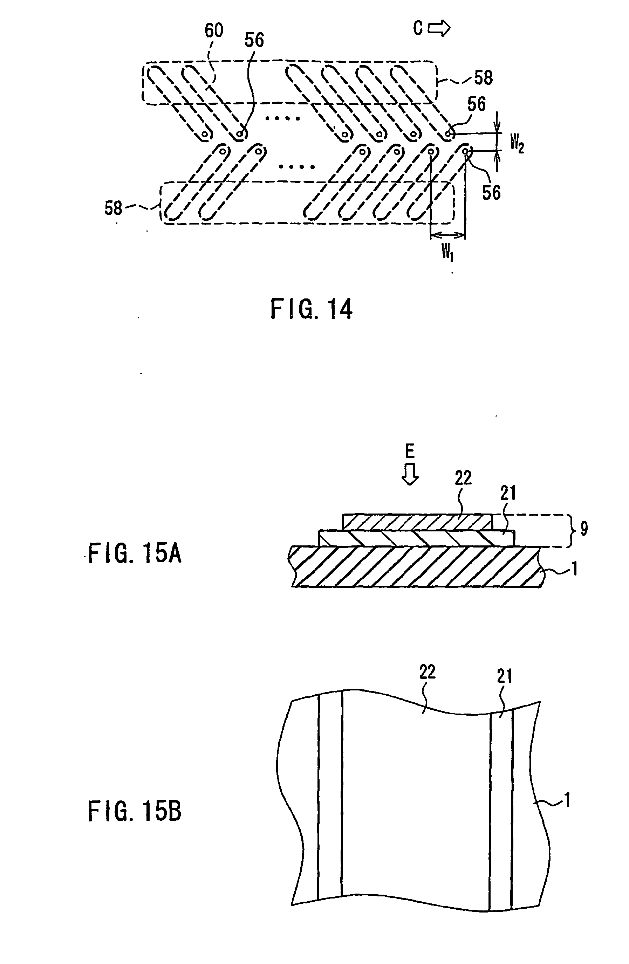

FIG. 14 shows an exemplary arrangement of the nozzle holes 56. FIG. 14 is a schematic view of the ink-jet head 52 seen from the nozzle hole side (for example, an arrow B side in FIG. 13A). An arrow C in FIG. 14 represents the direction in which the base 1 is fed. In the example shown in FIG. 14, the piezoelectric elements 60 are placed so as to respectively correspond to a plurality of nozzle holes 56. A plurality of the nozzle holes 56 are divided on a block basis, and the supply portion 58 is provided for each block. The arrangement of the nozzle holes 56 is not limited to the example shown in FIG. 14, and may be set arbitrarily.

In order to discharge the solution at a predetermined position on the surface of the base by the ink-jet method, it is preferable that the direction in which the solution is discharged from the nozzle holes and jetted to the surface of the base is constant at all times. In general, the jetting direction is set so as to be vertical to the surface of the base, or so as to be vertical to the surface where the nozzle holes of the ink-jet head are formed (nozzle surface: for example, a surface D shown in FIG. 13B). If the nozzle surface on the periphery of the nozzle holes does not repel the solution, the solution is likely to remain on the periphery of the nozzle holes. When the solution remains, the solution discharged from the nozzle holes may be attracted in the direction of the remaining solution due to the influence of surface tension. Then, the jetting direction of the solution is shifted from a predetermined direction, making it difficult to discharge the solution exactly. The nozzle surface generally is rendered water-repellent with fluorine resin or the like, and the surface energy thereof is set to be smaller than 20 dyne/cm. The surface energy of the discharging solution of the present invention and that of the solution used for the method for producing a pattern of the present invention are 20 dyne/cm or more. Therefore, the influence of the adhesion of the solution to the nozzle surface on the periphery of the nozzle holes can be suppressed.

According to the method for producing a pattern of the present invention, when the solution is discharged to the surface of the base, the surface temperature of the base may be set to be lower than the temperature of the solution to be discharged to the surface of the base by 5°C or higher. According to such a method for producing pattern, various patterns such as a repellent pattern, a metal pattern, a semiconductor pattern, and an insulator pattern can be formed while suppressing the influence of spreading, without previously forming a complementary repellent region on the surface of the base.

In the case of setting the surface temperature of the base to be lower than the temperature of the solution to be discharged to the surface of the base, the following phenomenon is considered to occur.

(a) The solution is cooled on the surface of the base, whereby the solubility of organic molecules having fluoroalkyl chains decreases. Therefore, the organic molecules are likely to adsorb to the surface of the base, and consequently, the surface energy of the base can be decreased efficiently.

(b) Along with a decrease in temperature of the solution, the molecular density of the organic molecules adsorbing to the surface of the base increases. Therefore, the density of $CF_3$ groups on the surface of the base increases, and the surface energy of the base decreases. The increase in molecular density of molecules adsorbing to the surface of the base due to the decrease in temperature is described in, for example, Journal of Physical Chemistry, vol. 98 (1994), p. 7557 to 7590. According to this literature, the organic molecules adsorbing to the surface of the base move around on adsorbed water present on the surface of the base due to the thermal diffusion. Then, as described above, the organic molecules gather due to the cohesion caused by Van der Waals force on the adsorbed water to form a monomolecular film. The in-plane configuration of the monomolecular film to be formed is controlled by the cohesive energy and thermal motion energy between molecules. As the temperature increases, the thermal motion energy becomes predominant, and the in-plane configuration of the monomolecular film is likely to be disturbed. In contrast, as the temperature decreases, the cohesive energy between the molecules becomes predominant, and the molecular density of the organic molecules increases.

Thus, the surface energy of the base can be decreased efficiently, so that a method for producing a pattern can be realized with the influence such as spreading further suppressed.

Hereinafter, more specific examples of the discharging solution of the present invention will be described.

As a first pattern formation material, a solution with a surface tension of 20 dyne/cm or more in which organic molecules having fluoroalkyl chains are dissolved is discharged to the surface of a base by the ink-jet method to perform drawing, and a solvent contained in the discharged solution is evaporated, whereby a repellent pattern can be formed.

Furthermore, by including a second pattern formation material in the solution, various patterns such as a metal pattern, a polymer pattern, a semiconductor pattern, and the like can be formed.

In this case, the surface tension of the solution may be, for example, in a range of 20 dyne/cm to 70 dyne/cm. The concentration of the organic molecules in the solution may be, for example, in a range of 0.0001 vol% to 30 vol%.

Furthermore, in the case where the viscosity of the above-mentioned solution is too high, the shape of the solution is unlikely to change. Therefore, the viscosity of the solution may be, for example, preferably, in a range of 0.5 c poise to 100 c poise (0,005 to 1 g/cm.s).

The organic molecules having fluoroalkyl chains that can be used for the discharging solution of the present invention can be classified, for example, into the following 7 kinds. The classification on the basis of a type shown below is not generalized as a technical common sense, and is used for convenience.

(1) Type 1: Organic molecules represented by Composition Formula: $CF_3(CF_2)_nC_2H_4R^2{}_aSiCl_{3-a}$ (where $R^2$ is a methyl group, an ethyl group, or a propyl group; $n$ is a natural number of 0 to 12; and $a$ is a natural number of 0 to 2). When $a = 2$, there are two $R^2$, and the kind of $R^2$ may be varied.

(2) Type 2: Organic molecules represented by Composition Formula: $CF_3(CF_2)_nC_2H_4R^3{}_aSi(OR^4)_{3-a}$ (where $R^3$ and $R^4$ are a methyl group, an ethyl group, or a propyl group; n is a natural number of 0 to 12; and a is a natural number of 0 to 2). When $a = 2$, there are two $R^3$, and the kind of $R^3$ may be varied.

(3) Type 3: Organic molecules represented by Composition Formula: $CF_3(CF_2)_nZ(CH_2)_mSH$ (where Z is (-O-CO-), (-CO-O-), or (NH-CO-); $n$ is a natural number of 0 to 12; and $m$ is a natural number of 0 to 20). Z may not be present.

(4) Type 4: Organic molecules represented by Composition Formula: $CF_3(CF_2)_nZ(CH_2)_mS-S(CH_2)_lY(CF_2)_n,CF_3$ (where Z and Y are (-O-CO-), (-CO-O-), or (NH-CO-); and $n$, $n'$, $m$, and $l$ are natural numbers of 0 to 20). Z and/or Y may not be present.

(5) Type 5: Organic molecules represented by Composition Formula: $CF_3(CF_2)_nC_2H_4COOH$. Organic molecules represented by Composition Formula: $CF_3(CF_2)_nC_2H_4CH_2OH$. Organic molecules represented by Composition Formula: $CF_3(CF_2)_nC_2H_4NH_2$. In these formulas, n is a natural number of 0 to 12.

(6) Type 6: Organic molecules represented by Composition Formula: $CF_3(CF_2)_nC_2H_4SiR^5R^6NHSiR^7R^8R^9$ (where $R^5$, $R^6$, $R^7$, $R^8$, and $R^9$ are a methyl group, an ethyl group, or a propyl group; and $n$ is a natural number of 0 to 12); or organic molecules represented by Composition Formula: $CF_3(CF_2)_nC_2H_4SiR^{10}R^{11}NHSiR^{12}R^{13}C_2H_4(CF_2)_mCF_3$ (where $R^{10}$, $R^{11}$, $R^{12}$, and $R^{13}$ are a methyl group, an ethyl group, or a propyl group; and n and m are natural numbers of 0 to 12).

(7) Type 7: Organic molecules represented by Composition Formula: $CF_3(GF_2)_nC_2H_4Si\{(O-CH_2CH_2)_m-OR\}_3$ (where R is a methyl group, an ethyl group, a propyl group, or a butyl group; and $n$ and $m$ are natural numbers of 1 to 10); or hydrolysates of the organic molecules.

The organic molecules of Type 1 are hydrolyzed easily in the presence of water due to the high reactivity with respect to active hydrogen. When a silanol group is generated due to the hydrolysis, and the generated silanol group is polymerized, a polymer of the organic molecules may be precipitated in the solution. Therefore, it is preferable to use a solvent free of active hydrogen and water. Examples of the solvent include chloroform, alkane containing about 6 to 16 carbon atoms (hexane, cyclohexane, heptane, octane, nonane, decane, undecane, dodecane, tridecane , tetradecane, pentadecane, hexadecane, and the like), xylene, toluene, and the like. These solvents may be used in combination.

Examples of the solvent used for the organic molecules of Type 2 include alcohols (ethanol, propanol, butanol, etc.), derivatives thereof (i.e., esters) (methoxyethanol, ethoxyethanol, ethylene glycol monoethyl ether, ethylene glycol monomethyl ether, etc.) and the like. The organic molecules of type 2 react with active hydrogen (a hydroxyl group, an amino group, a carboxy group, etc.) on the surface of the base to form siloxane bonds, thereby adsorbing to the surface of the base. However, the organic molecules of Type 2 have lower reactivity compared with that of the organic molecules of Type 1, and it is preferable that a small amount of water and/or an acid catalyst is added so as to promote the reaction.

Examples of the solvent used for the organic molecules of Types 3 and 4 include alcohols and derivatives thereof (i.e., esters) used for the organic molecules of Type 2, dichloromethane, and the like.

Examples of the solvent used for the organic molecules of Type 5 include the solvents used for the organic molecules of Type 1, esters used for the organic molecules of Type 2, and the like.

The organic molecules of Type 6 have high reactivity with respect to active hydrogen in the same way as in the organic molecules of Type 1. The organic molecules of Type 6 are hydrolyzed in the presence of water, and dissociated to two molecules each having a silanol group while generating ammonia. The silanol groups are subjected to dehydration polymerization to form siloxane bonds. Therefore, it is preferable to use a solvent free of active hydrogen and water in the same way as in the organic molecules of Type 1. For example, the solvents used for the organic molecules of Type 1 may be used. However, the reactivity of the organic molecules of Type 6 with respect to active hydrogen is not so high as that of the organic molecules of Type 1. Therefore, it is not necessary to remove water in the solvent to such a degree as that for the organic molecules of Type 1.

The organic molecules of Type 7 have high water-solubility For example, by emulsifying the organic molecules of Type 7 in the presence of a cationic surfactant, an anionic surfactant, or an amphoteric surfactant, an emulsion can be prepared. More specifically, by dissolving $CF_3(CF_2)_7C_2H_4Si(OC_2H_4OC_2H_4CH_3)_3$ as organic molecules and n-hexadecyltrimethylammonium chloride as a surfactant in pure water, a solution in which the organic molecules and a hydrolysate thereof are dissolved can be produced.

Herein, the organic molecules of Types (1) to (4), (6), and (7) can form covalent bonds with the surface of a base, or strong bonds similar to the covalent bonds. The organic molecules of Type (5) have a weaker binding force with respect to a base compared with the above-mentioned organic molecules. In general, the speed at which the organic molecules are bonded to the surface of a base to form a monomolecular film is controlled by the binding force between the organic molecules and the base. A portion of the organic molecules once bonded to a base leaves from the surface of the base with a certain probability. As the leaving probability is smaller, the speed at which the organic molecules form a monomolecular film on the surface of the base increases. The above-mentioned leaving probability of the organic molecules having the property of forming strong bonds with respect to the base is small. Thus, the speed at which the organic molecules forming strong bonds with respect to a base form a monomolecular film on the surface of the base is considered to be larger, compared with the case of the organic molecules that only can form weak bonds. Therefore, the speed at which the organic molecules of Types (1) to (4), (6), and (7) form a monomolecular film is assumed to be larger than that of the organic molecules of Type (5). Herein, the following is considered as follows. As the speed for forming a monomolecular film is larger, the period from the time when the solution is discharged to the surface of a base to the time when the solution shrinks due to a monomolecular film is shorter. Thus, by using solutions containing organic molecules of Types (1) to (4), (6) and (7), an exact pattern with the influence of spreading suppressed can be formed compared with the case of using a solution containing the organic molecules of Type (5).

If possible, the above-mentioned organic molecules of Types 1 to 7 may be mixed.

In the case of forming a metal pattern such as a circuit pattern, the above-mentioned solution for forming a repellent pattern may contain metal (e.g., metal colloid) as a second pattern formation material. The concentration of a metal colloid may be, for example, in a range of 0.001 wt% to 50 wt%.

If such a solution is discharged to the surface of a base to perform drawing, and a solvent contained in the solution is evaporated, the metal colloid is fused to form a metal pattern.

The metal colloid refers to metal particles with an average particle size of about several nanometers to several microns, and has the property of being dispersed in a solution. As a commercially available metal colloid, for example, there are gold and silver colloids. Furthermore, by modifying the surfaces of metal fine particles with organic molecules, a colloid of palladium, platinum, copper, or the like that is dispersible in an aqueous solution may be produced to be used. A method for producing such a metal colloid is disclosed by, for example, O. Tzhayik et al., Langmuir, vol. 18 (2002), p. 3364-3369, Y Zhou, Langmuir, vol. 18 (2002), p. 277-283, etc.

The metal colloid generally is dispersed in an aqueous solution (buffer solution). Therefore, as the organic molecules having fluoroalkyl chains, those which have a low reactivity with respect to water are preferable. In the case of using organic molecules having a high reactivity with water, a polymer of the organic molecules is precipitated in a solution, which may make it difficult to discharge the solution by the ink-jet method. For example, the above-mentioned organic molecules of Type 2, 3, 4, 5, or 7 may be used. Among them, the organic molecules of Type 7 are preferable due to the water solubility thereof.

In the case of using the organic molecules of Type 2, 3, 4, or 5, they are unlikely to be dissolved in water. Therefore, the following only needs to be performed: after these organic molecules are dissolved in solvents suitable for the respective types, a metal colloid is dissolved therein.

Furthermore, after a metal pattern is formed, the metal pattern may be heat-treated. The heat treatment can enhance the electrical characteristics of the metal pattern. For example, if the metal pattern is heat-treated at 400°C or higher, organic molecules having fluoroalkyl chains can be removed This can further enhance the conductivity of the metal pattern.

In the case of forming a conductive polymer pattern, the above-mentioned solution for forming a repellent pattern only needs to contain further a conductive polymer as a second pattern formation material. The concentration of the conductive polymer in the solution may be, for example, in a range of 1 wt% to 50wt%.

Such a solution is discharged to the surface of a base to perform drawing, and a solvent contained in the solution is evaporated, whereby a conductive polymer pattern can be formed.

There is no particular limit to a conductive polymer to be used. For example, a polymer having conjugated double bonds with an acceptor, donor molecules, or ions introduced therein may be used. More specifically, a polymer obtained by doping polyacetylene, polyphenylene, polypyrrole, polythiophene, polyquinoline, polypyridine, polyaniline, polyparaphenylene, polyparaphenylene vinylene, polythienylene vinylene, poly(3,4-ethylenedioxythiophene), polyfluorene, polyacene, a derivative thereof, or a mixture thereof with an acceptor, donor molecules, or ions may be used. For example, by doping polyacetylene with iodine, arsenic pentafluoride, or the like, a conductive polymer having a conductivity in a range of about 40 S/cm to 600 S/cm can be obtained. Furthermore, for example, by doping poly(3,4-ethylenedioxythiophene) with polystyrene sulfonate, a conductive polymer having a conductivity of about 100 S/cm can be obtained.

These conductive polymers generally are dissolved in an organic solvent. Therefore, as the organic molecules having fluoroalkyl chains, those which are likely to be dissolved in an organic solvent are preferable. For example, the above-mentioned organic molecules of Type 1, 2, 3, 4, or 6 may be used. Since poly(3,4-ethylenedioxythiophene) is dissolved in water, for example, the organic molecules of Type 5 or 7 may be used.

In the case of forming a semiconductor polymer pattern, the above-mentioned solution for forming a repellent pattern only needs to further contain a semiconductor polymer as a second pattern formation material. The concentration of the semiconductor polymer in the solution may be, for example, in a range of 0.001 wt% to 50wt%.

Such a solution is discharged to the surface of a base to perform drawing, and a solvent contained in the solution is evaporated, whereby a semiconductor polymer pattern can be formed.

There is no particular limit to a semiconductor polymer to be used. For example, a semiconductor polymer having conjugated double bonds may be used. More specifically, polythiophene, polypyrrole, polyaniline, polyalkylthiophene, poly-9,9'dialkyl-fluorene-co-bithiophene, or the like may be used.

These semiconductor polymers generally are dissolved in an organic solvent. Therefore, as the organic molecules having fluoroalkyl chains, those which are likely to be dissolved in an organic solvent are preferable. For example, the above-mentioned organic molecules of Type 1, 2, 3, 4, or 6 may be used.

In the case of forming a metal-oxide dielectric pattern, the above-mentioned solution for forming a repellent pattern only needs to contain further a metal-oxide dielectric or a precursor of a metal-oxide dielectric as a second pattern formation material. In the case of using the precursor of the metal-oxide dielectric, the concentration of the precursor may be, for example, in a range of 0.001 wt% to 50wt%.

Such a solution is discharged to the surface of a base to perform drawing, a solvent contained in the solution is evaporated, followed by heat treatment, to change the precursor to a metal-oxide dielectric, whereby a metal-oxide dielectric pattern can be formed. More specifically, first, a precursor pattern is formed, and then, a metal-oxide dielectric pattern is formed by heat treatment.

There is no particular limit to a precursor of a metal-oxide dielectric to be used. For example, the following may be used: metal alkoxide ($M(OR^{15})_x$ (where M is metal and/or silicon, x is an oxidation number of metal, and $R^{15}$ is a methyl group, an ethyl group, a propyl group, or a butyl group. In the case where $x$ is 2 or more, a plurality of different $R^{15}$ may be contained)); metal acetylacetonate ($M(COCH_2COCH_2)_x$ (where M is metal and/or silicon, and $x$ is an oxidation number of metal)); metal carboxylate ($M(R^{16}COO)_x$ (where M is metal and/or silicon, $x$ is an oxidation number of metal, and $R^{16}$ is an alkyl group. In the case where $x$ is 2 or more, a plurality of different $R^{16}$ may be contained)); a metal inorganic compound; and the like. An element $M$ may be at least one kind of element selected from, for example, silicon, titanium, zirconium, aluminum, copper, lead, indium, tin, zinc, yttrium, barium, nickel, andiron.

Metal alkoxide has the following property: a part of alkoxy groups in the molecules is hydrolyzed to hydroxy groups in the presence of water, and the hydroxy groups are subjected to dehydration polymerization. Furthermore, when a small amount of water and/or acid catalyst, or a small amount of alkali catalyst is added to a solution, a precursor is likely to change to a metal-oxide dielectric by heat treatment.

Metal alkoxide changes to a metal-oxide dielectric having a $MO_{x/2}$ composition by heat treatment (for example, sintering). Depending upon a heat treatment temperature (sintering temperature), a metal-oxide dielectric in which an unreacted alkoxyl group and hydroxy group remain is formed.

Similarly, in the case of using metal acetylacetonate and/or metal carboxylate as a precursor, a metal-oxide dielectric can be formed.

As organic molecules used for forming a metal-oxide dielectric pattern, for example, the above-mentioned organic molecules of Type 2 may be used. As a solvent, those which are suitable for the organic molecules of Type 2 may be used.

The heat treatment for changing a precursor pattern to a metal-oxide dielectric pattern may be performed, for example, in a range of 100°C to 1000°C, for example, in the atmosphere, in an atmosphere of inactive gas such as nitrogen or argon, or in an atmosphere of reducing gas such as hydrogen. Above all, it is preferable that the heat treatment is performed at 200°C or higher. In the case where sintering is performed at 300°C or higher, organic molecules having fluoroalkyl chains contained in a pattern can be removed.

In the case of forming an insulating polymer pattern, the above-mentioned solution for forming a repellent pattern only needs to further contain an insulating polymer as a second pattern formation material-The concentration of the insulating polymer in the solution may be, for example, in a range of 0.001 wt% to 50 wt%.

Such a solution is discharged to the surface of a base to perform drawing, and a solvent contained in the solution is evaporated, whereby an insulating polymer pattern can be formed.

In general, most of polymers are electrically insulative. Therefore, insulative polymers can be selected without any limit. However, in order to discharge a solution to the surface of a base by the ink-jet method, generally, it is necessary that a polymer is dissolved in the solution. Thus, it is preferable to use a polymer having a polar group, such as polyvinylphenol, polyvinylalcohol, or the like. Such a polymer is dissolved in an alcohol solvent. Therefore, as the organic molecules having fluoroalkyl chains, for example, the organic molecules of Type 2, 3, 4, or 5 that are likely to be dissolved in an alcohol solvent may be used.

In the case of forming a light-curable polymer pattern, the above-mentioned solution for forming a repellent pattern only needs to further contain a light-curable polymer as a second pattern formation material. The concentration of the light-curable polymer in the solution may be, for example, in a range of 0.001 wt% to 50 wt%.

Such a solution is discharged to the surface of a base to perform drawing, and a solvent contained in the solution is evaporated, followed by irradiation with light having a predetermined wavelength, whereby a light-curable polymer pattern can be formed. There is no particular limit to a light-curable polymer to be used.

Herein, the light-curable polymer refers to a polymer and/or a monomer that is subjected to polymerization and cross-linking by irradiation with an electromagnetic wave having a wavelength shorter than that of visible light such as a UV-ray, an electron beam, an X-ray, or the like. When such a reaction proceeds, the following phenomena occur: the molecular weight increases, and the solubility with respect to the solution changes. Specific examples of the light-curable polymer include a monomer having a light crosslinking functional group, and a polymer with a light cross-linking functional group introduced to a main chain or a side chain. Examples of the light cross-linking functional group include an azide group, a diazo group, a halogen group, a methyl group, and the like. More specifically, as the light-curable polymer, for example, a negative photoresist is widely known. Examples of a typical photoresist include a polymer in which aromatic bisazide is added to cyclized rubber as a light cross-linker, poly(glycidyl methacrylate), a methacrylic polymer containing a maleic acid ester, a glycidyl methacrylate - ethyl acrylate copolymer, chloromethylated polystyrene, iodized polystyrene, chlorinated poly(methylstyrene), and the like.

Most of these polymers are dissolved in an organic solvent. Therefore, as the organic molecules having fluoroalkyl chains, for example, the organic molecules of Type 1, 3, 4, or 6 that are likely to be dissolved in an organic solvent may be used.

Next, a method for producing an electric device of the present invention will be described.

The method for producing an electronic device of the present invention only needs to include the above-mentioned method for producing a pattern of the present invention. The electronic device in the present specification refers to elements or a collectivity thereof, for performing an operation, accumulation and transmission of information, display, and the like using the flow and accumulation of electrons.

For example, a solution having a surface tension of 20 dyne/cm or more, in which organic molecules having fluoroalkyl chains as a first pattern formation material, and at least one kind of material selected from a precursor of a metal-oxide dielectric, a semiconductor, metal, and a polymer as a second pattern formation material are dissolved, is discharged to the surface of a base by the ink-jet method to perform drawing. Then, a solvent contained in the discharged solution is evaporated, whereby a pattern containing the organic polymers and the second pattern formation material is formed. By repeating such steps, metal wiring, an electrode, a transistor, a resistor, a capacitor, a microlens, an imaging element, and the like can be produced. A method for forming only a repellent pattern may be used as well.

A more specific example will be described. In order to produce, for example, a display using an organic electroluminescent (EL) element with each pixel size being 50 $\mu$m x 50 $\mu$m, the following may be performed, for example. First, in a region other than the region on the surface of a substrate where an EL element is to be placed, a repellent pattern is formed by the method for producing a pattern of the present invention. Then, a pattern of an EL material is formed in the region other than that of the repellent pattern, whereby a pixel pattern of an EL display can be produced. Alternatively, a pattern containing an EL material may be formed by discharging a solution containing organic molecules having fluoroalkyl chains and an EL material to a region on the surface of a substrate where an EL element is to be placed by the ink-jet method, without forming a repellent pattern. According to the method for producing a pattern of the present invention, a pattern with the influence of spreading and the like suppressed can be formed. Therefore, a pixel pattern of an EL display can be produced without forming a repellent pattern.

Furthermore, if the above-mentioned method for producing a metal pattern and method for producing a conductive polymer pattern are used, for example, a printed substrate having a circuit pattern can be produced. Furthermore, if the method for producing a semiconductor polymer pattern is used, for example, a gate electrode, a source electrode, a semiconductor layer, and the like are formed, whereby a transistor can be produced. Furthermore, for example, an active layer of a thin film transistor is formed, whereby a thin film transistor can be produced.

If the above-mentioned method for producing a metal-oxide dielectric pattern and method for producing an insulating polymer pattern are used together, for example, a capacitor can be produced. If lead zirconate titanate (PZT) is used, a high-capacity capacitor can be produced. A resistor also can be produced.

If the above-mentioned method for producing a light-curable polymer pattern is used, for example, a lens can be produced. If a solution containing a light-curable polymer is discharged to the surface of a base, the discharged solution is repelled to form a substantially spherical surface, along with a decrease in surface energy of the base. If light having a predetermined wavelength is radiated in this state, a lens can be produced. If the decrease in the degree of the surface energy of the base is controlled, the shape of the lens can be controlled. The lens thus produced can be used as, for example, a microlens for enhancing the collecting power of a light-receiving portion of a CCD, and a lens for an optoelectronic device.

Next, the electronic device of the present invention will be described.

The electronic device of the present invention is produced by the above-mentioned method for producing a pattern of the present invention and/or the above-mentioned method for producing an electronic device of the present invention. According to the method for producing a pattern of the present invention, a pattern 9 as shown in FIG. 10D can be formed. Therefore, the electronic device of the present invention includes the pattern 9 as shown in FIG. 10D.

In other words, the electronic device of the present invention includes a pattern and a base 1 as shown in FIG. 15A The pattern 9 as shown in FIG. 15A is formed on the surface of the base 1. The pattern 9 includes a first pattern region 21 containing organic molecules having fluoroalkyl chains and a second pattern region 22 containing at least one selected from metal, a semiconductor, a metal oxide, and a polymer. On the surface of the base 1, the first pattern region 21 and the second pattern region 22 are stacked in this order. As shown in FIG. 15B, the shape of the first pattern region 21 is substantially similar to that of the second pattern region 22. Herein, the first pattern region 21 is the above-mentioned repellent pattern, and the second pattern region 22 may be a metal pattern or an insulating polymer pattern, depending upon the material contained therein. All the patterns included in the electronic device of the present invention are not required to have the configuration as shown in FIGS. 15A and 15B. Only a partial pattern needs to have the configuration shown in FIGS. 15A and 15B. Furthermore, in the electronic device of the present invention, a material contained in the second pattern region 22 may be mixed in the first pattern region 21, and alternatively, a material contained in the first pattern region 21 may be mixed in the second pattern region 22.

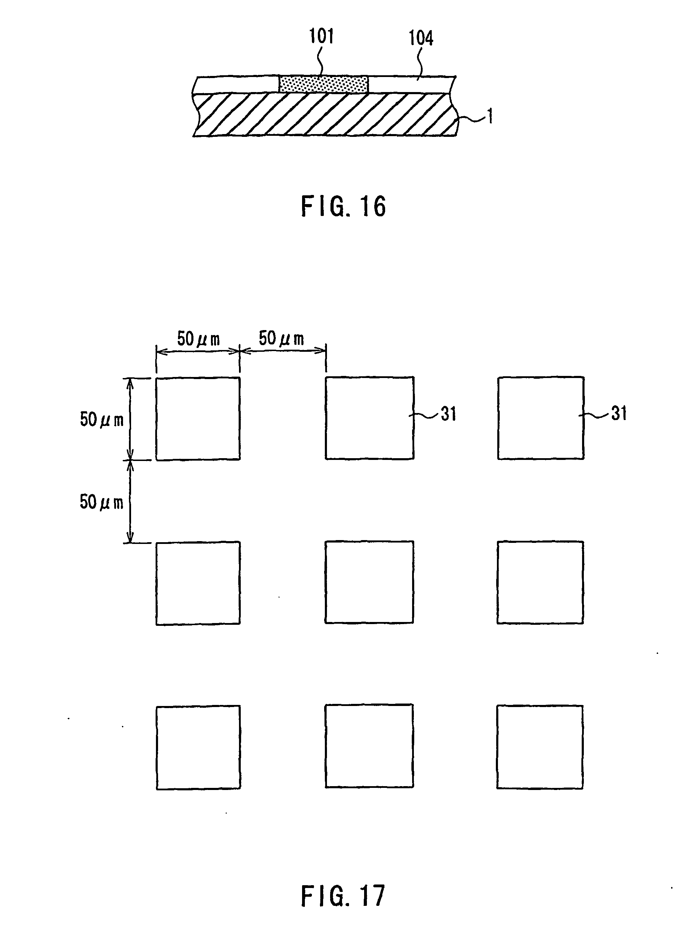

As described above, conventionally, a pattern is formed after forming a complementary repellent region. FIG. 16 is a schematic view showing an example of a conventional pattern. A pattern 101 shown in FIG. 16 is formed on the surface of the base 1, and in a portion other than the pattern 101 on the surface of the base 1, a complementary repellent region 104 is formed. The pattern 101 is formed so as to be in contact with the surface of the base 1. Furthermore, according to the conventional method, the complementary repellent region 104 is not required, so that the complementary repellent region 104 may be removed by irradiation with a UV-ray after forming the pattern 101.

In contrast, in the pattern 9 shown in FIG. 15, the second pattern region 22 is formed on the first pattern region 21. The first pattern region 21 contains organic molecules having fluoroalkyl chains, and is chemically stable. Furthermore, the first pattern region 21 contains a monomolecular film of the above-mentioned organic molecules. Therefore, the pattern 9 can be rendered excellent in resistance to an environment such as high temperature. That is, the electronic device of the present invention is excellent in resistance to an environment such as high temperature. For example, the case where the second pattern region 22 contains a polymer will be considered. In general, a pattern containing a polymer is exposed to an environment in the vicinity of a thermosoftening point of the contained polymer, the flowability of the polymer is enhanced, whereby the polymer may spread outside of the pattern region to deform the shape of the pattern. On the other hand, in the pattern 9 shown in FIG. 15A, even in the case where the flowability of the second pattern region 22 is enhanced, the polymer contained in the second pattern region 22 can be suppressed from spreading outside of the region due to the function of the first pattern region 21 present between the second pattern region 22 and the base 1.

Furthermore, in the pattern 9 shown in FIG. 15, the second pattern region 22 can be removed from the surface of the base 1 simultaneously with the removal of the first pattern region 21. For example, if the base 1, and the first pattern region 21 and the second pattern region 22 are soaked in a solvent that dissolves the first pattern region 21, the first pattern region 21 is dissolved, and the second pattern region 22 can be removed. Therefore, a material (second pattern formation material) contained in the second pattern region 22 can be collected easily. That is, the electronic device of the present invention can be rendered excellent in recycling of a constituent material.

There is no particular limit to a base to which the discharging solution of the present invention is discharged, a base to which the method for producing a pattern of the present invention is applicable, a base to which the method for producing an electronic device of the present invention is applicable, and a base used for the electronic device of the present invention. For example, any material such as resin, metal, ceramics, or the like can be used as the base. The state of the base is not particularly limited, and the base may be, for example, in a solid state or in a gel state. The base also may have a porous structure. The shape of the base is not particularly limited. The base may be, for example, a plate-shaped base (substrate), or a base having a curved surface. In general, it is considered to be difficult to apply a photolithographic method or the like to a porous base, a curved base, or the like. Therefore, it is difficult to form a complementary repellent region on a porous base or a curved base, and hence, it is difficult to apply the above-mentioned conventional method. In contrast, according to the discharging solution of the present invention or the method for producing a pattern of the present invention, a pattern with spreading suppressed more exactly can be formed even on a porous base or a curved base.

Examples

Hereinafter, the present invention will be described more specifically by way of examples. The present invention is not limited to the following

examples.

Example 1

In Example 1, repellent patterns were formed on the surface of a silicon wafer, using a silicon wafer as a base.

-Preparation of a base-

A silicon wafer (thickness: 200 $\mu$m; diameter: 100 mm) with a thermally grown oxide film was soaked in a mixed solution (80°C) of ammonia water and a hydrogen peroxide solution for 30 minutes. Thereafter, the silicon wafer was washed with pure water to remove dirt such as an organic substance and an inorganic substance adhering to the surface of the silicon wafer. Then, moisture adhering to the silicon wafer is removed with nitrogen gas, and then, the silicon wafer was irradiated with a UV-ray at 110°C in an ozone atmosphere for 15 minutes, whereby the dirt of the organic substance was removed completely. The surface of the silicon wafer subjected to the above treatments was completely wet with water and confirmed to be clean.

-Preparation of a discharging solution-

A dehydrator ("Molecular Sieve", produced by Kanto Chemical Co., Ltd.) was placed in chloroform, and left for 12 hours, whereby water remaining in chloroform was removed. Then, 1 vol% of heptadecafluoloethyltrichloro silane ($CF_3(CF_2)_7C_2H_4SiCl_3$: hereinafter, this also is referred to as "FCS") was dissolved as organic molecules having fluoroalkyl chains in the above-mentioned chloroform to produce a discharging solution. The surface tension of the solution thus produced was 28 dyne/cm. The produced solution (FCS solution) was accommodated in an ink-jet head 52 shown in FIG. 13A. These operations were performed at a relative humidity of 1% or less in a nitrogen atmosphere. In the ink-jet head 52, a width $W_1$ and a width $W_2$ shown in FIG. 14 were set to be 340 $\mu$m and 170 $\mu$m.

For comparison, general black ink for an ink-jet printer also was prepared. The ink contained a black dye, water, diethylene glycol, and glycerine, and the like as main components, and the surface tension thereof was 30 dyne/cm.

The surface tension was measured by a so-called ring method. Specifically, first, a metallic ring with a radius R formed by bending a platinum wire in a circular shape was prepared. The thickness of the platinum wire was set to be about 0.2 mm, and the radius R thereof was set to be about 10 mm. Then, the metallic ring was brought into contact with a solution to be measured in parallel with the liquid surface thereof. Thereafter, the metallic ring was pulled up in a vertical direction to the liquid surface, and a force P required for detaching the metallic ring from the liquid surface was obtained. The surface tension $\gamma$ of the solution was obtained by Expression: $\gamma = P/(4\pi R)$.

-Discharging and drawing onto a silicon wafer-

Discharging and drawing onto a silicon wafer were performed by an ink-jet apparatus shown in FIG. 12. The relative movement between an ink-jet head and a silicon wafer, and the control of discharging of a solution onto the silicon wafer were performed using a computer. As a result, patterns 31 were drawn in which squares (50 $\mu$m $\times$ 50 $\mu$m) as shown in FIG. 17 were arranged at an interval of 50 micrometers. A solution to be discharged was a chloroform solution of FCS, so that the patterns 31 were repellent patterns. The discharging frequency of a liquid was 10 KHz, and the amount of liquid droplets was 20 picoliters (16.8 $\mu$m in terms of an average radius of a liquid droplet). After drawing, the silicon wafer was left in a nitrogen atmosphere for about 10 minutes, and taken out to the atmosphere. The atmosphere temperature during drawing was adjusted so as to be in a range of 25 $\pm$ 1°C. Furthermore, the silicon wafer was placed on a Peltier device, and the surface (discharging surface) temperature of the silicon wafer was controlled in a range of -10°C to 25°C.

-Evaluation method-

The drawn and formed patterns were evaluated regarding the following three items.

(a) The silicon wafer with the patterns 31 formed thereon was exposed to an atmosphere of a temperature of 25°C and a relative humidity of 100%, and the surface thereof was observed with an optical microscope. Under this humidity, water in the air condenses on the surface of the silicon wafer. Therefore, a uniform water film is formed in a region of the silicon wafer having hydrophilicity, while minute water droplets are formed in a region of the silicon wafer having water repellency. When these regions are observed with an optical microscope, a portion where minute water droplets are formed is observed to be clouded since light is reflected randomly in this portion. Thus, by measuring the shape and area of the clouded portion on the silicon wafer, the shape and the average value of areas of actually drawn repellent patterns can be derived. The average value of areas was obtained by averaging the areas of 10 drawn patterns.

(b) Similarly, a silicon wafer with black ink drawn thereon was observed with an optical microscope, and the shape and the average value of areas of actually drawn patterns were derived. The average value of areas was obtained by averaging the areas of 10 drawn patterns.

(c) A region where fluorine elements or carbon elements were present on the surface of each silicon wafer, on which an FCS chloroform solution or black ink has been discharged, was estimated with an X-ray microanalyzer. In the silicon wafer on which the FCS chloroform solution has been discharged, the region where fluorine elements were present became repellent patterns. In the silicon wafer on which black ink has been discharged, the region where carbon elements were present became patterns formed of black ink. The shape of each pattern and the area thereof were obtained by the methods similar to the above-mentioned items (a) and (b).

-Results-

Table 1 shows the results of the observation with a microscope.

Table 1

| Discharged solution | Surface temperature of base (°C) | Average value pattern area observed to be clouded ($\mu m^2$) | of black value of black ink pattern area ($\mu m^2$) | Shape of pattern to observed to be clouded or black ink pattern |
|---|---|---|---|---|
| FCS solution | 25 | 3000 | - | Square |
| FCS solution | 10 | 2900 | - | Square |
| FCS solution | 0 | 2800 | - | Square |
| FCS solution | -5 | 2600 | - | Square |
| Black ink | 25 | - | 8000 | Circle |
| Black ink | 10 | - | 8000 | Circle |
| Black ink | 0 | - | 7900 | Circle |
| Black ink | -5 | - | 6000 | Oval |

As shown in Table 1, in the silicon wafers on which the FCS chloroform solution has been discharged, square repellent patterns were observed. The average value of the formed areas was within 120% of an intended pattern area of 2500 $\mu m^2$. From these results, it is understood that, in the case of discharging the FCS chloroform solution, the solution was suppressed from spreading on the surface of the silicon wafer, and repellent patterns with the influence of spreading and the like suppressed were formed. On the other hand, in the case of discharging general black ink, the shape of formed patterns was circular or oval due to the spreading of black ink. The average area of the patterns was remarkably larger than that in the case of using the FCS chloroform solution.

Furthermore, there was a tendency that, as the temperature of the base (i.e., silicon wafer) decreases, the average value of areas of the formed repellent patterns approaches an intended pattern area of 2500 $\mu m^2$. The reason for this is considered as follows: the surface temperature of the base decreases with respect to the temperature of the solution to be discharged, whereby the discharged solution becomes unlikely to spread on the silicon wafer. On the other hand, even in the case of discharging black ink, when the temperature of the wafer surface was -5°C, the average area of patterns decreased slightly, and the shape of the patterns became circle or oval. The reason for this is considered as follows: the viscosity of black ink increases along with a decrease in temperature of the wafer surface, whereby black ink becomes unlikely to spread on the wafer surface.

Next, Table 2 shows the results of the measurement with an X-ray microanalyzer. As shown in Table 2, even in the measurement with an X-ray microanalyzer, the results similar to those of the observation with a microscope were obtained.

Table 2

| Discharged solution | Surface temperature of base (°C) | Distribution area of fluorine elements ($\mu m^2$) | Distribution area of carbon elements ($\mu m^2$) | Shape of region where fluorine elements are present or region where carbon elements are present |
|---|---|---|---|---|
| FCS solution | 25 | 3000 | - | Square |
| FCS solution | 10 | 2900 | - | Square |
| FCS solution | 0 | 2800 | - | Square |
| FCS solution | -5 | 2600 | - | Square |
| Black ink | 25 | - | 8000 | Circle |
| Black ink | 10 | - | 8000 | Circle |
| Black ink | 0 | - | 7900 | Circle |
| Black ink | -5 | - | 6000 | Oval |

Example 2

A solution containing organic molecules having fluoroalkyl chains was discharged to a silicon wafer for evaluation in the same way as in Example 1. The discharging solution was produced by dissolving 1 vol% of heptadecafluoroethyl-trimethoxy silane ($CF_3(CF_2)_7C_2H_4Si(OCH_3)_3$; hereinafter, this may be referred to as "FAS") in 2-ethoxyethanol as organic molecules having fluoroalkyl chains, and adding 2 ml of 1 N hydrochloric acid to 100 ml of the produced solution, followed by stirring for one hour. The surface tension of the produced discharging solution (FAS solution) was 32 dyne/cm. Furthermore, the relative humidity of the environment for producing the FAS solution and the environment for discharging the FAS solution was set to be in a range of 20% to 50%, which was not particularly controlled unlike Example 1.
The patterns similar to those in Example 1 were formed and evaluated. Consequently, the same results as those in Example 1 were obtained. More specifically, square repellent patterns were formed irrespective of the surface temperature of the base. The average value of areas of the formed repellent patterns was within 120% of an intended pattern area of 2500 $\mu m^2$. Furthermore, there was a tendency that, as the surface temperature of the base decreases, the average value of areas of the formed repellent patterns approaches the intended pattern area in the same way as in Example 1.

Example 3

A solution containing organic molecules having fluoroalkyl chains was discharged to the surface of a base for evaluation in the same way as in Example 1. The base was obtained by vapor-depositing gold (thickness: 10 nm) onto a silicon substrate, which had been washed by the same method as that in Example 1, by vacuum sputtering. The discharging solution was obtained by dissolving 1 vol% of $CF_3(CF_2)_5(CH_2)SH$ in ethanol as organic molecules having fluoroalkyl chains. The surface tension of the solution was 25 dyne/cm. The relative humidity of the environment for producing the above solution and the environment for discharging the solution was set to be in a range of 20% to 50%, which was not particularly controlled unlike Example 1.
The patterns similar to those in Example 1 were formed and evaluated. Consequently, the same results as those in Example 1 were obtained. More specifically, square repellent patterns were formed irrespective of the surface temperature of the base. The average value of areas of the formed repellent patterns was within 120% of an intended pattern area of 2500 $\mu m^2$. Furthermore, there was a tendency that, as the surface temperature of the base decreases, the average value of areas of the formed repellent patterns approaches the intended pattern area in the same way as in Example 1.

Example 4

A solution containing organic molecules having fluoroalkyl chains was discharged to a silicon wafer for evaluation in the same way as in Example 1. The discharging solution was obtained by dissolving 1 vol% of $CF_3(CF_2)_7C_2H_4COOH$ in ethanol as organic molecules having fluoroalkyl chains. The surface tension of the solution was 25 dyne/cm. The relative humidity of the environment for producing the above solution and the environment for discharging the solution was set to be in a range of 20% to 50%, which was not particularly controlled unlike Example 1.

The patterns similar to those in Example 1 were formed and evaluated. Consequently, the same results as those in Example 1 were obtained. More specifically, square repellent patterns were formed irrespective of the surface temperature of the base. The average value of areas of the formed repellent patterns was within 120% of an intended pattern area of 2500 $\mu m^2$. Furthermore, there was a tendency that, as the surface temperature of the base decreases, the average value of areas of the formed repellent patterns approaches the intended pattern area in the same way as in Example 1.

Example 5

A solution containing organic molecules having fluoroalkyl chains was discharged to a silicon wafer, on which gold was vapor-deposited, for evaluation in the same way as in Example 3. The discharging solution was obtained by dissolving 1 vol% of $CF_3(CF_2)_7C_2H_4SH$ in ethanol as organic molecules having fluoroalkyl chains. The surface tension of the solution was 25 dyne/cm. The relative humidity of the environment for producing the above solution and the environment for discharging the solution was set to be in a range of 20% to 50%, which was not particularly controlled unlike Example 1.

The patterns similar to those in Example 1 were formed and evaluated. Consequently, the same results as those in Example 1 were obtained. More specifically, square repellent patterns were formed irrespective of the surface temperature of the base. The average value of areas of the formed repellent patterns was within 120% of an intended pattern area of 2500 $\mu m^2$. Furthermore, there was a tendency that, as the surface temperature of the base decreases, the average value of areas of the formed repellent patterns approaches the intended pattern area in the same way as in Example 1.

Example 6

A solution containing organic molecules having fluoroalkyl chains was discharged to a silicon wafer, on which gold was vapor-deposited, for evaluation in the same way as in Example 3. The discharging solution was obtained by dissolving 1 vol% of $CF_3(CF_2)_7C_2H_4S_2C_2H_4(CF_2)_7CF_3$ in ethanol as organic molecules having fluoroalkyl chains. The surface tension of the solution was 25 dyne/cm. The relative humidity of the environment for producing the above solution and the environment for discharging the solution was set to be in a range of 20% to 50%, which was not particularly controlled unlike Example 1.

The patterns similar to those in Example 1 were formed and evaluated. Consequently, the same results as those in Example 1 were obtained. More specifically, square repellent patterns were formed irrespective of the surface temperature of the base. The average value of areas of the formed repellent patterns was within 120% of an intended pattern area of 2500 $\mu m^2$. Furthermore, there was a tendency that, as the surface temperature of the base decreases, the average value of areas of the formed repellent patterns approaches the intended pattern area in the same way as in Example 1.

Example 7

A solution containing organic molecules having fluoroalkyl chains was discharged to a silicon wafer for evaluation in the same way as in Example 1. The discharging solution was obtained by dissolving 1 vol% of $CF_3(CF_2)_7C_2H_4Si(CH_3)_2NHSi(CH_2CH_2CH_3)_3$ in chloroform as organic molecules having fluoroalkyl chains. The surface tension of the solution was 28 dyne/cm. The relative humidity of the environment for producing the above solution and the environment for discharging the solution was set to be in a range of 20% to 50%, which was not particularly controlled unlike Example 1.

The patterns similar to those in Example 1 were formed and evaluated. Consequently, the same results as those in Example 1 were obtained. More specifically, square repellent patterns were formed irrespective of the surface temperature of the base. The average value of areas of the formed repellent patterns was within 120% of an intended pattern area of 2500 $\mu m^2$. Furthermore, there was a tendency that, as the surface temperature of the base decreases, the average value of areas of the formed repellent patterns approaches the intended pattern area in the same way as in Example 1.

Example 8

A solution containing organic molecules having fluoroalkyl chains was discharged to a silicon wafer for evaluation in the same way as in Example 1. The discharging solution was obtained by diluting a repellent solution A shown below with water so that the concentrations of $CF_3(CF_2)_7C_2H_4Si(OC_2H_4OC_2H_4CH_3)_3$ and a hydrolysate thereof were 0.5 wt%. The surface tension of the solution was 50 dyne/cm. The relative humidity of the environment for producing the above solution and the environment for discharging the solution was set to be in a range of 20% to 50%, which was not particularly controlled unlike Example 1.

The patterns similar to those in Example 1 were formed and evaluated. Consequently, the same results as those in Example 1 were obtained. More specifically, square repellent patterns were formed irrespective of the surface temperature of the base. The average value of areas of the formed repellent patterns was within 120% of an intended pattern area of 2500 $\mu m^2$. Furthermore, there was a tendency that, as the surface temperature of the base decreases, the average value of areas of the formed repellent patterns approaches the intended pattern area in the same way as in Example 1.

-Repellent solution A-

The repellent solution A was produced as follows.

First, 200 ml of heptane and 20 ml of $CF_3(CF_2)_7C_2H_4SiCl_3$ were mixed in a round bottom flask provided with an inlet port and an outlet port for gas. Mixing was performed in a glove box filled with dry nitrogen gas. Then, the dry nitrogen gas was introduced from the gas inlet port of the round bottom flask. The flask was kept warm in an oil bath at 80°C while the inside of the flask was maintained in a dry atmosphere. Furthermore, while the solution in the flask was being stirred, $CH_3OC_2H_4OC_2H_4OH$ was dropped by 20 mL After the completion of dropping, the solution was continued to be stirred (12 hours). After the completion of stirring, heptane in the flask was evaporated to be removed with a vacuum evaporator. Thus, $CF_3(CF_2)_7C_2H_4Si(OC_2H_4OC_2H_4CH_3)_3$ with a purity of about 100% was obtained.

Next, while 2.4 wt% of an aqueous solution of n-hexadecyltrimethylammonium chloride was being stirred, the produced $CF_3(CF_2)_7C_2H_4Si(OC_2H_4OC_2H_4CH_3)_3$ was dissolved to set the concentration of $CF_3(CF_2)_7C_2H_4Si(OC_2H_4OC_2H_4CH_3)_3$ to be 8 wt%. After the stirring of the resultant solution continued for about 30 minutes, it was left for 24 hours without stirring. Thus, an aqueous solution in which $CF_3(CF_2)_7C_2H_4Si(OC_2H_4OC_2H_4CH_3)_3$ and a hydrolysate thereof were dissolved was produced. The aqueous solution thus produced is a repellent solution A. n-hexadecyltrimethylammonium chloride plays a role of promoting the dissolution of $CF_3(CF_2)_7C_2H_4Si(OC_2H_4CH_4CH_3)_3$ and the hydrolysate thereof in water. The repellent solution A is disclosed by, for example, U.S. Patent No. 5,550,184.

Example 9

In Example 9, using a silicon wafer as a base, gold patterns were formed as metal patterns on the surface the silicon wafer.

The silicon wafer used as the base was prepared in the same way as in Example 1.

The discharging solution was prepared as follows.

First, an ethanol solution, in which 10 vol% of $CF_3(CF_2)_7C_2H_4COOH$ was dissolved as organic molecules having fluoroalkyl chains, was prepared. Then, 10 ml of the ethanol solution was dissolved in 90 ml of a mixed solution (pH = 6.5, produced by Kanto Chemical Co., Ltd.) of sodium citrate and sodium carbonate in which 0.01 wt% of gold colloid particles (average particle size: 20 nm) were dispersed. Thus, a solution was produced in which 1 vol% of $CF_3(CF_2)_7C_2H_4COOH$ and the gold colloid particles were dissolved. The surface tension of the produced solution was 50 dyne/cm. The produced solution was accommodated in the ink-jet head similar to that in Example 1.

Furthermore, for comparison, the gold colloid solution that was the same as the above except for $CF_3(CF_2)_7C_2H_4COOH$ was dissolved was prepared separately.

Each solution prepared as described above was discharged to the surface of a silicon wafer in the same way as in Example 1, followed by sintering at 450°C for 30 minutes. The shape of gold patterns thus formed and the average value of areas thereof were evaluated. The evaluation was performed by observation with an optical microscope and measurement with an X-ray microanalyzer. Unlike the repellent patterns in Example 1, the gold patterns can be observed even without forming water droplets. Therefore, the observation with an optical microscope was performed at room temperature and a relative humidity of about 40% to 70%.

Table 3 shows the results of the observation with a microscope.

Table 3

| Discharged liquid | Surface temperature of base (°C) | Average value of gold pattern area ($\mu m^2$) | Shape of gold pattern |
|---|---|---|---|
| Gold colloid solution containing $CF_3(CF_2)_7C_2H_4COOH$ | 25 | 2900 | Square |
| | 10 | 2800 | Square |
| | 0 | 2700 | Square |
| | -5 | 2600 | Square |
| Gold colloid solution (not containing $CF_3(CF_2)_7C_2H_4COOH$) | 25 | 8000 | Circle |
| | 10 | 8000 | Circle |
| | 0 | 8200 | Circle |
| | -5 | 8000 | Circle |

As shown in Table 3, in the case of discharging the gold colloid solution containing $CF_3(CF_2)_7C_2H_4COOH$, gold patterns in a square shape were observed. Furthermore, the average value of formed areas was within 120% of an intended pattern area of 2500 $\mu m^2$. From these results, it is understood that, in the case of discharging the gold colloid solution containing $CF_3(CF_2)_7C_2H_4COOH$, the solution was suppressed from spreading on the surface of a silicon wafer, and gold patterns were formed with the influence of spreading and the like suppressed. On the other hand, in the case of discharging the gold colloid solution not containing $CF_3(CF_2)_7C_2H_4COOH$, the shape of formed gold patterns was circle due to spreading. The average area of patterns was remarkably larger than that in the case of using the gold colloid solution containing $CF_3(CF_2)_7C_2H_4COOH$.

Furthermore, there was a tendency that, as the temperature of the base (i.e., silicon wafer) decreases, the average value of areas of the formed gold patterns approaches an intended pattern area of 2500 $\mu m^2$. The reason for this is considered as follows: the surface temperature of the base decreases with respect to the temperature of the solution to be discharged, whereby the discharged solution becomes unlikely to spread on the silicon wafer.

Next, Table 4 shows the results of the measurement with an X-ray microanalyzer with respect to the gold patterns formed by discharging the gold colloid solution containing $CF_3(CF_2)_7C_2H_4COOH$. As shown in Table 4, most of the elements detected with the X-ray microanalyzer were gold. From this result, it is understood that $CF_3(CF_2)_7C_2H_4COOH$ contained in the discharging solution was thermally decomposed due to the sintering after discharging, whereby the gold patterns in which $CF_3(CF_2)_7C_2H_4COOH$ hardly remained were formed.

Table 4

| Discharged solution | Temperature of base (°C) | Ratio of detected elements (%) | |
|---|---|---|---|
| Gold colloid solution containing $CF_3(CF_2)_7C_2H_4COOH$ | 25 | Gold | 95 |
| | | Carbon | 2 |
| | | Fluorine | 2 |
| | | Oxygen | 0.5 |
| | | Silicon | 0.5 |

Example 10

In Example 10, gold patterns that were metal patterns were formed on the surface of a silicon wafer in the same way as in Example 9. As the discharging solution, the repellent solution A produced in Example 8 was used in place of $CF_3(CF_2)_7C_2H_4COOH$. More specifically, the concentrations of $CF_3(CF_2)_7C_2H_4Si(OC_2H_4OC_2H_4CH_3)_3$ and a hydrolysate thereof in the discharging solution were adjusted to be 0.5 wt%. The surface tension of the produced solution was 50 dyne/cm.

Using the discharging solution thus produced, gold patterns were formed in the same way as in Example 9, and the shape and average value of areas of the gold patterns were evaluated. Consequently, gold patterns in a square shape were formed in the same way as in Example 9. Furthermore, the average value of areas of the formed gold patterns was within 120% of an intended pattern area of 2500 $\mu m^2$. Thus, it is understood that, even in the case of using water-soluble organic molecules as the organic molecules having fluoroalkyl chains, patterns with the influence of spreading and the like suppressed can be formed. Such water-soluble organic molecules are suitable for discharging a water-soluble metal colloid by the ink-jet method.

Example 11

In Example 11, conductive polymer patterns were formed on the surface of a silicon wafer using the same method as that in Example 9.

The discharging solution was obtained by mixing the repellent solution Ain a poly(3,4-ethylenedioxythiophene) aqueous solution doped with 30 wt% of polystyrene sulfonate (Baytron P (Trade Name), produced by Bayer). More specifically, the concentrations of $CF_3(CF_2)_7C_2H_4Si(OC_2H_4OC_2H_4CH_3)_3$ and a hydrolysate thereof in the discharging solution were adjusted to be 0.5 wt%. The surface tension of the produced solution was 50 dyne/cm.

Using the discharging solution thus produced, conductive polymer patterns were formed in the same way as in Example 9, and the shape and average value of areas of the conductive polymer patterns were evaluated. The evaluation was performed after the solution was discharged and dried at room temperature for about 30 minutes.

Consequently, conductive polymer patterns in a square shape were confirmed to be formed. Furthermore, the average value of areas of the conductive polymer patterns was within 120% of an intended pattern area of 2500 $\mu m^2$.

For comparison, conductive polymer patterns were formed similarly under the condition that the repellent solution A was not added. Consequently, the shape of the formed patterns was circular due to the influence of spreading. Furthermore, the average value of areas of the patterns was 10 times or more the intended pattern area of 2500 $\mu m^2$.

Example 12

In Example 12, semiconductor polymer patterns were formed, and thin film transistors (TFTs) were formed.

As a base, a high-doped n-type silicon wafer (thickness: 200 $\mu m$; diameter: 100 mm) with a thermally grown oxide film (thickness: 200 nm) on only one side was used. The silicon wafer was treated in the same way as in Example 1, whereby dirt of an organic substance and an inorganic substance adhering to the surface of the silicon wafer was removed completely. The surface of the treated silicon wafer was confirmed to be completely wet with water and clean.

The discharging solution in which a semiconductor polymer was dissolved was obtained by dissolving FCS as organic molecules having fluoroalkyl chains and poly-9,9'dioctyl-fluorene-co-bithiophene (hereinafter, this also may be referred to as "F8T2") as a semiconductor polymer in chloroform. The concentration of the respective molecules in chloroform was adjusted to be 1 vol%. The surface tension of the solution was 28 dyne/cm. The solution thus produced was accommodated in an ink-jet head in the same way as in Example 1.

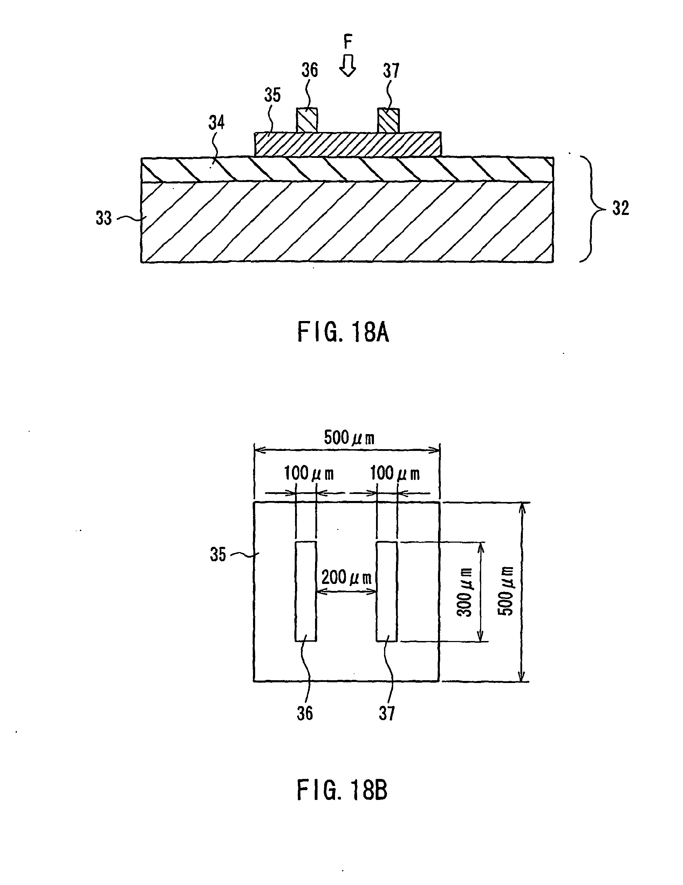

Next, the discharging solution was discharged to the silicon wafer in the same way as in Example 1, whereby a TFT as shown in FIGS. 18A and 18B was formed. Specifically, in a prepared silicon wafer 32 with a thermally grown oxide film, n-type silicon 33 was a gate electrode, and a thermally grown oxide film 34 was a gate insulating film. Herein, the discharging solution in which a semiconductor polymer (F8T2) was dissolved was discharged to the surface of the thermally grown oxide film 34 to perform drawing, whereby a semiconductor polymer pattern 35 was formed as an active layer. The semiconductor polymer pattern 35 thus formed had a square shape with each side being 500 $\mu m$ as shown in FIG. 18B. The semiconductor polymer pattern 35 was formed in a glove box (room temperature) filled with dry nitrogen. Then, using a shadow mask and vapor deposition, a source electrode 36 and a drain electrode 37 made of gold were formed on the semiconductor polymer pattern 35. The area of the source electrode 36 and the drain electrode 37 was 300 $\mu m \times 100 \mu m$. The gate length was 200 $\mu m$. FIG. 18B is a view seen from above the TFT shown in FIG. 18A (from an arrow F shown in FIG. 18A).

Furthermore, for comparison, the F8T2 solution containing no FCS was prepared, and TFTs were formed similarly.

The TFTs thus formed were evaluated as follows.

(a) Evaluation of the shape of the semiconductor polymer pattern

The shape of the formed semiconductor polymer pattern (F8T2 film) was evaluated with an optical microscope and a differential interferometer.

(b) Evaluation of the characteristics of the transistor

A mobility $\mu$ of the TFTs was obtained from a relational equation (Equation (2) shown below) between a source-drain current I and a gate voltage Vg. The potential of the source electrode was assumed to be 0 V.

$$I = \mu \times C \times W/L \times \{(Vg - Vt) \times Vd - 1/2 \times Vd^2\} \qquad (2)$$

where, in Equation (2),

W is a width of the source and drain electrodes (300 $\mu$m),
L is a gate length (200 $\mu$m),
Vd is a voltage applied to the drain electrode,
Vg is a gate voltage,
Vt is a gate voltage at which a source-drain current starts flowing, and
C is a capacity of a capacitor formed of a gate insulating film.

Table 5 shows the results of the evaluation.

Table 5

| Presence/absence of FCS in discharging solution | Mobility $\mu$ (cm$^2$/Vs) | Shape of F8T2 film |
|---|---|---|
| Presence | $30 \times 10^{-4}$ | Square (530 $\mu$m $\times$ 530 $\mu$m) |
| Absence | $7 \times 10^{-4}$ | Circle (diameter: about 3000 $\mu$m) |

As shown in Table 5, in the case of discharging the F8T2 solution containing FCS, F8T2 patterns in a square shape (530 $\mu$m $\times$ 530 $\mu$m) were formed. More specifically, semiconductor polymer patterns were formed with the influence of spreading suppressed. In contrast, in the case of discharging the F8T2 solution containing no FCS, the formed F8T2 patterns had a circular shape with a diameter of about 3000 $\mu$m, which was found to be largely influenced by spreading.

Furthermore, the mobility of the TFTs formed using the F8T2 containing FCS was larger by about four times, compared with the case of using the solution containing no FCS. The reason for this is considered to be as follows: when the F8T2 solution containing FCS contacted the thermally grown oxide film 34, a monomolecular film of FCS was formed on the thermally grown oxide film 34. More specifically, the following is considered: in the case where a monomolecular film is formed on the thermally grown oxide film 34, the monomolecular film acts like a liquid crystal alignment film, whereby the alignment of the F8T2 molecules to be deposited on the monomolecular film is controlled. When the alignment of the F8T2 molecules is controlled, alkyl chains in the molecules are aligned in one direction, and conjugated double bonds are arranged in a line, whereby electrons may be likely to flow. The phenomenon in which the electron mobility is enhanced by forming an organic semiconductor on the monomolecular film also is reported by Salleo et al. (A. Salleo et al., Applied Physics, vol. 81 (2002), p. 4383).

In other words, by using the discharging solution of the present invention (using the method for producing a pattern or the method for producing an electronic device of the present invention), higher-speed TFTs can be realized.

Example 13

In Example 13, metal-oxide dielectric patterns were formed on the surface of a silicon wafer (base) with a thermally grown oxide film.

As the base, a silicon wafer prepared in the same way as in Example 1 was used.

Three kinds of discharging solutions were prepared. Each discharging solution was produced by placing a solution B shown in Table 6 in a glass beaker, and dropping a solution C little by little while stirring the solution with a stirrer. After the completion of dropping of the solution C, stirring was continued for about one hour. TIP and CZ in Table 6 have high reactivity with water, and molecules thereof are polymerized to be insolubilized in the presence of water. Therefore, acetylacetone was mixed for the purpose of stabilizing the solution. In each discharging solution, the organic molecules having fluoroalkyl chains were FAS, and the precursor of a metal-oxide dielectric was TEOS, TIP, or CZ. The surface tensions of the silicon oxide precursor solution, titanium oxide precursor solution, and zirconium oxide precursor solution were 40 dyne/cm, 30 dyne/cm, and 30 dyne/cm.

Furthermore, for comparison, solutions containing no FAS were produced respectively.

Table 6

| Kind of precursor of metal oxide | Solution B | | Solution C | |
|---|---|---|---|---|
| Silicon oxide precursor | Ethanol | 30 ml | Ethanol | 30 ml |
| | TEOS | 30 ml | Pure water | 20 ml |
| | FAS | 5 ml | 36 vol% hydrochloric acid | 1.5 ml |
| Titanium oxide precursor | 2-propanol | 25 ml | 2-propanol | 25 ml |
| | TIP | 12 ml | Pure water | 2 ml |
| | FAS | 2 ml | 36 vol% hydrochloric acid | 0.2 ml |
| | Acetylacetone | 3 ml | | |
| Zirconium oxide precursor | 2-propanol | 25 ml | 2 propanol | 25 ml |
| | CZ | 12 ml | | |
| | FAS | 2 ml | Pure water | 2 ml |
| | Acetylacetone | 3 ml | 36 vol% hydrochloric acid | 0.2 ml |
| Abbreviations in Table 6 are as follows: FAS: heptadecafluoloethyltrimethoxy silane ($CF_3(CF_2)_7C_2H_4Si(OCH_3)_3$) TEOS: tetraethoxysilane ($Si(OC_2H_5)_4$) TIP: titanium isopropoxide ($Ti(OCHCH_3CH_3)_4$) CZ: zirconium octanoate ($Zr(OO(CH_2)_7CH_3)_4$) | | | | |

Each solution prepared as described above was discharged to the surface of a silicon wafer in the same way as in Example 1, followed by sintering (in the atmosphere, 450°C, 30 minutes). The shape and average value of areas of metal-oxide dielectric patterns thus formed were evaluated. The evaluation was performed in the same way as in Example 9.

Table 7 shows the results of the evaluation.

Table 7

| Kind of precursor | Surface temperature of base (°C) | Case of containing FAS | | Case of containing no FAS | |
|---|---|---|---|---|---|
| | | area Pattern ($\mu m^2$) | Pattern shape | Pattern area ($\mu m^2$) | Pattern shape |
| Silicon oxide | 25 | 2900 | Square | 6000 | Circle |
| | 4 | 2700 | Square | 5700 | Circle |
| Titanium oxide | 25 | 3000 | Square | 7000 | Circle |
| | 4 | 2800 | Square | 6000 | Circle |
| Zirconium oxide | 25 | 3000 | Square | 7000 | Circle |
| | 4 | 2700 | Square | 6000 | Circle |

As shown in Table 7, in the case of discharging the solution containing FAS, metal-oxide dielectric patterns in a square shape were observed. Furthermore, the average value of areas of the formed patterns was within 120% of an intended pattern area of 2500 $\mu m^2$. From these results, it is understood that, in the case of discharging the solution containing FAS, the solution was suppressed from spreading on the surface of the silicon wafer, and metal-oxide dielectric patterns were formed with the influence of spreading and the like suppressed. On the other hand, in the case of discharging the solution containing no FAS, the shape of the formed metal-oxide dielectric patterns was circle due to the spreading. The average value of areas of the patterns was remarkably larger than that of the case of using the solution containing FAS.

Furthermore, there was a tendency that, as the temperature of the silicon wafer decreases, the average value of areas of the formed metal-oxide dielectric patterns approaches the intended pattern area of 2500 $\mu m^2$. The reason for this is considered as follows: the surface temperature of the base decreases with respect to the temperature of the solution to be discharged, whereby the discharged solution becomes unlikely to spread on the silicon wafer.

Example 14

In Example 14, insulating polymer patterns were formed on the surface of a silicon wafer (base) with a thermally grown oxide film.

As the base, a silicon wafer prepared in the same way as in Example 1 was used.

The discharging solution was obtained by dissolving FAS in an isopropyl alcohol solution (concentration: 30 wt%) of polyvinyl phenol so that the concentration of FAS was 1 vol% as the organic molecules having fluoroalkyl chains. The surface tension of the solution was 27 dyne/cm.

Furthermore, for comparison, a solution containing no FAS (the other conditions were the same) was prepared.

Each solution prepared as described above was discharged to the surface of the silicon wafer in the same way as in Example 1, and the shape and average value of areas of the formed insulating polymer patterns were evaluated. The evaluation was performed in the same way as in Example 9.

Table 8 shows the results of the evaluation.

Table 8

| Surface temperature of base | Case of containing FAS | | Case containing no FAS | |
|---|---|---|---|---|
| | Pattern area ($\mu m^2$) | Pattern shape | Pattern area ($\mu m^2$) | Pattern shape |
| 25 | 2800 | Square | 5000 | Circle |
| 10 | 2650 | Square | 4000 | Circle |

As shown in Table 8, in the case of discharging the solution containing FAS, insulating polymer patterns in a square shape were observed Furthermore, the average value of areas of the formed patterns was within 120% of an intended pattern area of 2500 $\mu m^2$. From these results, it is understood that, in the case of discharging the solution containing FAS, the solution was suppressed from spreading on the surface of the silicon wafer, and insulating polymer patterns were formed with the influence of spreading and the like suppressed. On the other hand, in the case of discharging the solution containing no FAS, the shape of the formed insulating polymer patterns was circular due to the spreading. The average value of areas of the patterns was remarkably larger than that of the case of using the solution containing FAS.

Furthermore, there was a tendency that, as the temperature of the silicon wafer decreases, the average value of areas of the formed insulating polymer patterns approaches the intended pattern area of 2500 $\mu m^2$. The reason for this is considered as follows: the surface temperature of the base decreases with respect to the temperature of the solution to be discharged, whereby the discharged solution becomes unlikely to spread on the silicon wafer.

Example 15

In Example 15, a resistor was formed.

As the base, a silicon wafer with a thermally grown oxide film treated in the same way as in Example 1 was used.

As the discharging solution, an isopropyl alcohol solution was used, in which 30 wt% of polyvinyl alcohol, 10 wt% of carbon powder with an average particle size of about 2 $\mu m$, and 1 vol% of $CF_3(CF_2)_7C_2H_4SH$ as organic molecules having fluoroalkyl chains were dissolved. The surface tension of the solution was 28 dyne/cm. Furthermore, for comparison, a solution containing no $CF_3(CF_2)_7C_2H_4SH$ was prepared.

Using the respective solutions thus prepared, resistors were formed. Specifically, first, a copper thin film was formed on the surface of a silicon wafer in a square shape of 200 $\mu m$ × 200 $\mu m$ by electron beam (EB) vapor deposition using a shadow mask. The copper thin film corresponds to a lower electrode.

Next, the discharging solution was discharged to a center portion of the copper thin film in a square shape of 100 $\mu m$ × 100 $\mu m$ in the same way as in Example 1. Thereafter, the entire silicon wafer was heated at 80°C for one hour to dry the discharged solution, whereby a resistor film was formed. Finally, a copper thin film in a square shape of 50 $\mu m$ × 50 $\mu m$ was formed in a center portion of the formed resistive film by the EB vapor deposition using a shadow mask. The finally formed copper thin film corresponds to an upper electrode.

The resistors thus formed were evaluated as follows.

(a) Evaluation of the shape of the formed resistive film

The shape of the resistive film (polyvinyl alcohol film containing carbon powder) formed on the lower electrode was evaluated by an optical microscope.

(b) Evaluation of the characteristics of the resistor

A current flowing when a DC voltage of 3 V was applied between the lower electrode and the upper electrode of the formed resistor was measured, and a resistance σ of the resistor was obtained. Specifically, the resistance o was obtained by the following Equation (3).

$$\text{Resistance } \sigma = (V \cdot S)/(I \cdot d) \qquad (3)$$

where S is the area of the upper electrode; V is a voltage applied between the upper electrode and the lower electrode; I is a current flowing between the upper electrode and the lower electrode; and d is the thickness of the resistive film. The thickness of the resistive film was measured using a thickness meter before forming the upper electrode.

As a result of the evaluation, in the case of using a solution containing $CF_3(CF_2)_7C_2H_4SH$, the shape of the resultant resistive film was a substantially square, and was in a range of 110 $\mu$m $\times$ 110 $\mu$m. In contrast, in the case of using the solution containing no $CF_3(CF_2)_7C_2H_4SH$, the shape of the resultant resistive film was a circle due to the influence of spreading. Furthermore, the resistive film was formed extending from the surface of the lower electrode, and its diameter was about 5000 $\mu$m.

Furthermore, the resistance of the resistor produced using the solution containing $CF_3(CF_2)_7C_2H_4SH$ was about 1 k$\Omega$cm, and hence, it was found that this resistor functions sufficiently.

Example 16

A capacitor was formed in Example 16.

As the base, a silicon wafer treated in the same way as in Example 1 was used.

The discharging solution was obtained by dissolving $Pb(OCOCH_3)_2 \cdot 3H_2O$, $Ti[OCH(CH_3)_2]_4$, and $Zr(OC_4H_9)_4$ in 2-methoxy ethanol. The above-mentioned solution was prepared so that the element ratio among Pb, Ti, and Zr was 1:0.47:0.53. Furthermore, the concentration of the solution was adjusted with 2-ethoxyethanol so that the viscosity of the solution was 2c poise. FAS was dissolved in a concentration of 1 vol% in the solution thus produced as organic molecules having fluoroalkyl chains. The surface tension of the finally obtained solution was 30 dyne/cm.

A capacitor was formed using the discharging solution thus prepared. First, a platinum thin film in a square shape of 200 $\mu$m $\times$ 200 $\mu$m was formed on a silicon wafer by the EB vapor deposition using a shadow mask. The platinum thin film corresponds to a lower electrode. Then, the discharging solution was discharged to a center portion of the platinum thin film in a square shape of 100 $\mu$m $\times$ 100 $\mu$m in the same way as in Example 1. After discharging, the entire silicon wafer was heat-treated at 450°C for 20 minutes, whereby a dielectric film was formed. Finally, a copper thin film was formed in a square shape of 50 $\mu$m $\times$ 50 $\mu$m in the center portion of the dielectric film by the EB vapor deposition using a shadow mask. The copper thin film corresponds to an upper electrode.

Furthermore, for comparison, a solution containing no FAS (the other conditions were the same) was prepared, and a capacitor was formed in the same way.

The capacitors thus formed were evaluated as follows.

(a) Evaluation of the shape of the formed dielectric film

The shape of the dielectric film formed on the platinum thin film (i.e., lower electrode) was evaluated by an optical microscope.

(b) Evaluation of characteristics of the capacitor

An AC voltage (amplitude: 5 V; frequency: 1 kHz) was applied between the lower electrode and the upper electrode of the formed capacitor, whereby a capacitive current was obtained. Furthermore, when the dielectric film was formed on the platinum thin film, the thickness of the dielectric film was previously measured with a thickness meter, and a relative dielectric constant was obtained from the capacitive current and the thickness.

In the case of discharging the solution containing FAS, the shape of the resultant dielectric film was substantially square, and was in a range of 110 $\mu$m $\times$ 110 $\mu$m. In contrast, in the case of discharging the solution containing no FAS, the resultant dielectric film was a circle due to the influence of spreading. Furthermore, the dielectric film thus obtained was formed extending from the surface of the lower electrode, and its diameter was about 6000 $\mu$m.

Furthermore, the relative dielectric constant of the capacitor produced using the solution containing FAS was 600, and hence, it was found that this capacitor functions sufficiently.

Example 17

In Example 17, a microlens was formed on a CCD that is a kind of a solid-state imaging device.

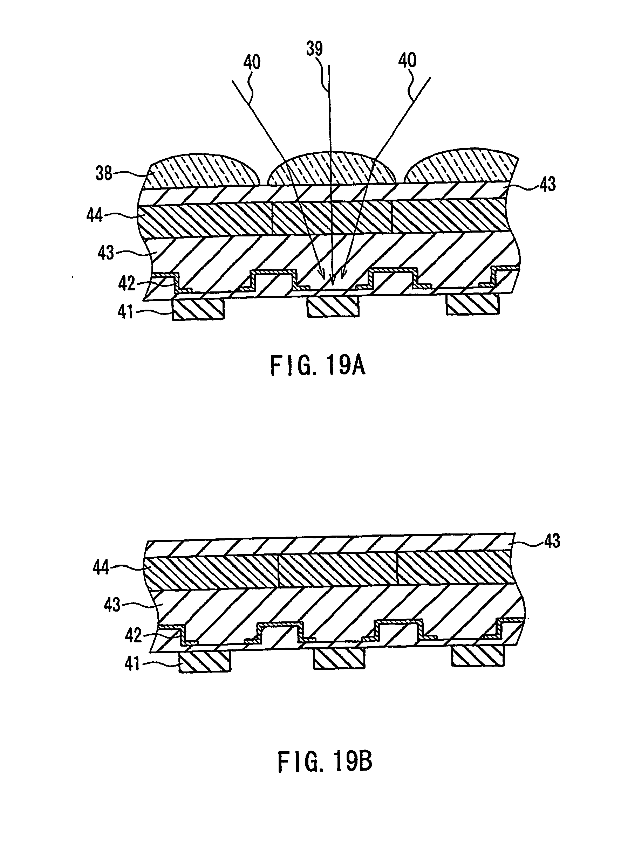

FIG. 19Ais a cross-sectional schematic view of a general CCD. A microlens 38 is placed on an uppermost portion of the CCD. The microlens 38 plays a role of collecting light 40 diagonally incident upon the CCD, as well as light 39 incident vertically upon the CCD to optical sensors 41. By collecting the diagonally incident light 40 onto optical sensors 41, the total amount of light received by the CCD can be increased. Furthermore, the CCD generally includes, as a structure, silicon oxide 43 having light transparency, a light-blocking plate 42 for suppressing the incidence of light upon a region other than the optical sensors 41, a color filter 44, and the like.

In Example 17, using a CCD (number of pixels: 30,000; overall size: 12 mm $\times$ 10 mm; pixel size: 60 $\mu$m $\times$ 60 $\mu$m, produced by Matsushita Electric Industrial Co., Ltd.) having no microlens, a discharging solution was discharged to the CCD (principal surface of the CCD on a side opposite to the surface on which the optical sensors 41 is placed) to form a microlens.

A discharging solution was used in which a UV-curable polymer (Shipley 1400-27, produced by Shipley) was diluted with thinner (produced by Shipley) to set the viscosity to be 2c poise (0,02g/cm.s), and FCS was dissolved in a concentration of 0.5 vol% as organic molecules having fluoroalkyl chains. The surface tension of the solution was 30 dyne/cm. Furthermore, the production and discharging of the solution were performed in a glove box filled with dry nitrogen gas.

Using the solution thus prepared, a microlens was formed. Specifically, only one liquid droplet with a diameter of 20 $\mu$m was discharged to the point on the surface directly above each optical sensor 41 on the CCD by the ink-jet method similar to that in Example 1. Then, the discharged solution was irradiated with a UV-ray using a high-pressure mercury lamp for about 60 seconds, whereby the solution was cured to form a microlens. The irradiation energy was set to be 15.8 mW/cm$^2$.

Furthermore, for comparison, a discharging solution containing no FAS (the other conditions are the same) was produced, and a microlens was formed on a CCD similarly.

The microlenses thus formed were evaluated as follows.

(a) Evaluation of the shape of the microlens

The shape of the microlens formed on the CCD was evaluated with an optical microscope.

(b) Evaluation of the characteristics of the CCD formed on the microlens

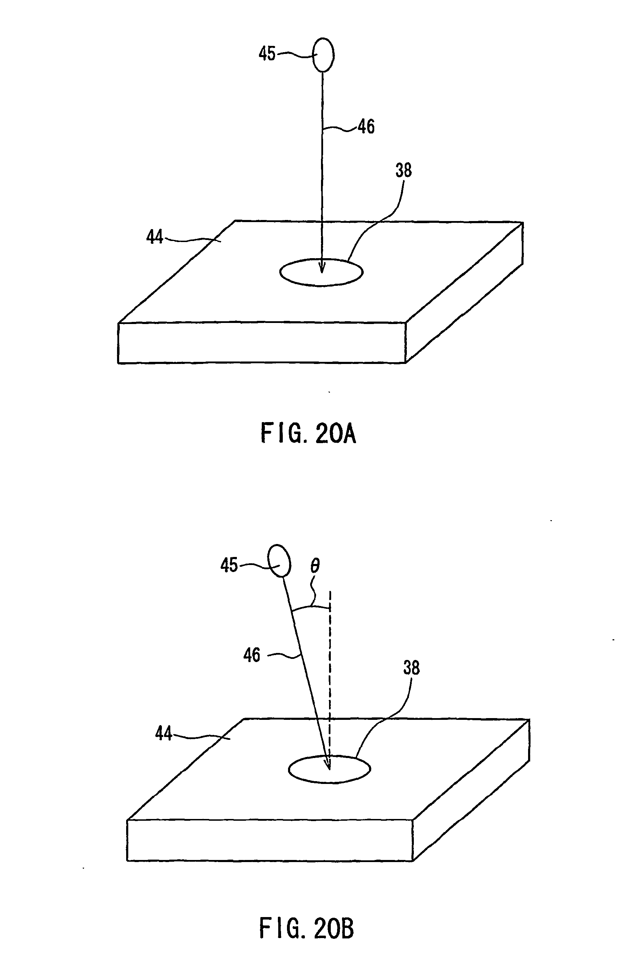

As shown in FIG. 20A, a halogen lamp 45 with a light bulb having a diameter of about 3 mm was placed at a position of 200 mm right above the center of a CCD 44. Light 46 is radiated from the halogen lamp 45 to the CCD 44, and the average of the amount of light received per optical sensor of the CCD 44 was measured. An average of the received light amount was evaluated using an average value of 30,000 optical sensors contained in the CCD 44. In FIG. 20A, for ease of understanding, only one microlens on the CCD 44 is shown. This also applies to FIG. 20B.

Then, as shown in FIG. 20B, the position of the halogen lamp 45 was shifted slightly from the vertical direction from the center of the CCD 44 (tilted at an angle of θ shown in FIG. 20B), whereby the average of the amount of light received per optical sensor of the CCD 44 was measured. The angle θ was set to be 10°.

As a result of the evaluation, in the case of using the discharging solution containing FCS, the microlens was formed at a position where the liquid droplet was discharged, and it had a lens shape. In contrast, in the case of using the discharging solution containing no FCS, the discharged liquid droplet spread over the entire discharged surface, whereby a thin film covering the entire discharged surface was formed. That is, a lens was not formed.

Next, the results will be shown, obtained by measuring the received light amounts of the CCD in which the microlens was formed with the discharging solution containing FCS and the CCD in which the microlens was not formed. Herein, the average of the received light amount in the case of placing the lamp as shown in FIG. 20A is assumed to be $I_0$, and the average of the received light amount in the case of placing the lamp as shown in FIG. 20B is assumed to be $I_1$.

In the presence of a microlens: $I_1/I_0$ = 0.98

In the absence of a microlens: $I_1/I_0$ = 0.7

Thus, the microlens formed in Example 17 was confirmed to achieve its function sufficiently.

Example 18

In Example 18, light-curable polymer patterns were formed, and the thermal stability of the formed light-curable polymer patterns was evaluated.

As the base, a silicon wafer treated in the same way as in Example 1 was used. Furthermore, as the discharging solution, the same solution as that in Example 17 was used.

Next, the above-mentioned discharging solution was discharged to the surface of the silicon wafer by the ink-jet method in the same way as in Example, 1, thereby drawing patterns shown in FIG. 17. The silicon wafer was dried at room temperature for 30 minutes after drawing, and irradiated with light using a mercury lamp to cure the polymer, whereby light-curable polymer patterns as shown in FIG. 17 were formed.

Furthermore, for comparison, the patterns shown in FIG. 17 were formed using the base and the discharging solution (containing no FCS) similar to those described above and a photoresist method. First, the discharging solution containing no FCS was applied to the surface of the silicon wafer by spin coating, followed by being dried for 30 minutes. Then, a photomask (square patterns are transparent), in which square patterns with one side being 50 $\mu$m were formed at an interval of 50 $\mu$m, was brought into contact with a light-curable polymer layer placed on the surface of the base, and irradiated with a UV-ray. Finally, the surface of the silicon wafer was washed with thinner, whereby light-curable polymer patterns as shown in FIG. 17 were formed.

The patterns thus formed were left for a predetermined period of time together with the base in a thermostat at 80°C, and thereafter, the change in the shape of the patterns was observed with an optical microscope. The change in the shape of the patterns was evaluated using the average value of 30 patterns (50 $\mu$m $\times$ 50 $\mu$m). Table 9 shows the results.

Table 9

| Leaving time in thermostat (hour) | Shape of pattern formed by ink-jet method | Shape of pattern formed by photolithography |
|---|---|---|
| 0 | Square (50 $\mu$m $\times$ 50 $\mu$m) | Square (50 $\mu$m $\times$ 50 $\mu$m) |
| 1 | Square (50 $\mu$m $\times$ 50 $\mu$m) | Square (50 $\mu$m $\times$ 50 $\mu$m) |
| 5 | Square (50 $\mu$m $\times$ 50 $\mu$m) | Square (60$\mu$m $\times$ 60$\mu$m) Rondure is formed at corner portions of a square |
| 10 | Square (50 $\mu$m $\times$ 50 $\mu$m) | Square (60 $\mu$m $\times$ 60 $\mu$m) Rondure is formed at corner portions of a square |
| 24 | Square (50 $\mu$m $\times$ 50 $\mu$m) | Circle (diameter: about 65 $\mu$m) |
| 48 | Square (50 $\mu$m $\times$ 50 $\mu$m) | Circle (diameter: about 70 $\mu$m) |
| 100 | Square (50 $\mu$m $\times$ 50 $\mu$m) | Circle (diameter: about 80 $\mu$m) |
| 200 | Square (50 $\mu$m $\times$ 50 $\mu$m) | Circle (diameter: about 100 $\mu$m) |

As is shown in Table 9, the light-curable polymer patterns formed by the Ink-jet method kept the initial shape even after being left in the thermostat at 80°C for 200 hours. In contrast, the shape of the light-curable polymer patterns formed by the photoresist method changed with the passage of time, and became a circle after being left for 24 hours in the thermostat. Furthermore, when the light-curable polymer patterns were further left in the thermostat, the shape of the patterns were deformed further.

From the above results, it was found that the patterns formed by the method for producing a pattern of the present invention was kept in a stable shape even in a high-temperature environment. That is, it was found that these patterns had excellent characteristics of environmental resistance. The reason for this is assumed to be as follows. In the patterns formed by the method for producing a pattern of the present invention, a monomolecular film of organic molecules having fluoroalkyl chains adsorbs to the interface between the surface of the base and the formed patterns. More specifically, it is assumed that, in a high-temperature environment, even in the case where the flowability of a polymer constituting the patterns is increased, the flow of the polymer is suppressed by the monomolecular film.

Industrial Applicability

As described above, using the discharging solution of the present invention, a pattern with spreading suppressed can be formed without previously forming a complementary repellent region on the surface of a base. The discharging solution of the present invention may be discharged to the surface of the base, for example, by the ink-jet method. Furthermore, according to the method for producing a pattern of the present invention, a pattern with spreading suppressed can be formed without previously forming a complementary repellent region on the surface of the base. Therefore, a method for producing a pattern has superior productivity. The discharging solution and the method for producing a pattern of the present invention are applicable to the production of various electronic devices, such as the production of a circuit pattern on a printed wiring board and an organic EL pixel, the production of an organic thin film transistor circuit, and the like. Furthermore, the present invention also is applicable to the method for producing a repellent pattern with increased productivity.

**Claims**

1. A discharging solution for forming patterns on a surface of a base, comprising organic molecules having fluoroalkyl chains as a first pattern formation material,
wherein the organic molecules are at least one selected from the group consisting of: organic molecules containing at least one group selected from a chlorosilyl group, an alkoxy group, and a mercapto group, organic molecules of a straight chain containing a carboxy group or hydroxy group or an amino group; disulfide; silazane; and dithiol; wherein the surface tension of the solution is 0.02 N/m (20 dyne/cm) or more.

2. The discharging solution according to claim 1, further comprising a second pattern formation material.

3. The discharging solution according to claim 2, wherein the second pattern formation material contains at least one kind of material selected from the group consisting of a precursor of a metal-oxide dielectric, a semiconductor, metal, and a polymer.

4. The discharging solution according to claim 3, wherein the second pattern formation material is the metal and the metal is a metal colloid.

5. The discharging solution according to claim 3, wherein the second pattern formation material is the polymer and the polymer is at least one kind selected from the group consisting of a conductive polymer, a semiconductor polymer, an insulating polymer, and a light-curable polymer.

6. The discharging solution according to claim 1, wherein the organic molecules are at least one selected from the group consisting of molecules represented by a composition formula: $CF_3(CF_2)_nC_2H_4Si\{(O\text{-}CH_2CH_2)_m\text{-}OR^1\}_3$, and hydrolysate of the molecules, and
in the composition formula, $R^1$ is a methyl group, an ethyl group, a propyl group, or a butyl group, and $n$ and $m$ are natural numbers of 1 to 10.

7. The discharging solution according to claim 3, wherein the second pattern formation material is the precursor of the metal-oxide dielectric and the precursor of the metal-oxide dielectric is at least one selected from the group consisting of metal alkoxide, metal acetylacetonate, metal carboxylate, and a metal inorganic compound.

8. The discharging solution according to claim 5, wherein the polymer is the semiconductor polymer and the semiconductor polymer is at least one selected from the group consisting of polyalkylthiophene and poly-9,9'dialkyl-fluorene-co-bithiophene.

9. The discharging solution according to claim 1, wherein a boiling point of a solvent contained in the solution is 80°C or higher.

10. The discharging solution according to claim 1, wherein the solution is applicable for forming patterns on a surface of a base by an inkjet method.

11. A method for producing patterns comprising:

discharging a solution having a surface tension of 0.02 N/m (2O dyne/cm) or more, in which organic molecules having fluoroalkyl chains are dissolved as a first pattern formation material, to a surface of a base by an inkjet method to perform drawing;
wherein the organic molecules are at least one selected from the group consisting of: organic molecules containing at least one group selected from a chlorosilyl group, an alkoxy group, and a mercapto group, organic molecules of a straight chain containing a carboxy group or hydroxy group or an amino group; disulfide; silazane; and dithiol; and
evaporating a solvent contained in the discharged solution to form patterns containing the organic molecules.

**12.** The method for producing patterns according to claim 11, the solution further comprising a second pattern formation material, the method comprising evaporating a solvent contained in the discharged solution to form patterns containing the organic molecules and the second pattern formation material.

**13.** The method for producing patterns according to claim 12, comprising evaporating a solvent contained in the discharged solution to form patterns including a first pattern region containing a relatively large amount of the organic molecules and a second pattern region containing a relatively large amount of the second pattern formation material, wherein the patterns are formed so that the first pattern region is present on the base side with respect to the second pattern region.

**14.** The method for producing patterns according to claim 12, wherein the second pattern formation material contains at least one kind of material selected from the group consisting of a precursor of a metal-oxide dielectric, a semiconductor, metal, and a polymer.

**15.** The method for producing patterns according to claim 14, wherein the second pattern formation material is the metal and the metal is a metal colloid.

**16.** The method for producing patterns according to claim 14, wherein the second pattern formation material is the polymer and the polymer is at least one kind selected from the group consisting of a conductive polymer, a semiconductor polymer, an insulating polymer, and a light-curable polymer

**17.** The method for producing patterns according to claim 11, wherein the organic molecules are at least one selected from the group consisting of molecules represented by a composition formula:
$CF_3(CF_2)_nC_2H_4Si\{(O\text{-}CH_2CH_2)_m\text{-}OR^1\}_3$, and hydrolyzate of the molecules, and
in the composition formula, $R^1$ is a methyl group, an ethyl group, a propyl group, or a butyl group, and $n$ and $m$ are natural numbers of 1 to 10.

**18.** The method for producing patterns according to claim 14, wherein the second pattern formation material is the precursor of the metal-oxide dielectric and the precursor of the metal-oxide dielectric is at least one selected from the group consisting of metal alkoxide, metal acetylacetonate, metal carboxylate, and a metal inorganic compound

**19.** The method for producing patterns according to claim 16, wherein the polymer is the semiconductor polymer and the semiconductor polymer is at least one selected from the group consisting of polyalkylthiophene and poly-9,9'-dialkyl-fluorene-co-bithiophene

**20.** The method for producing patterns according to claim 11, wherein a boiling point of the solvent is 80°C or higher.

**21.** The method for producing patterns according to claim 11, wherein, when the solution is discharged to the surface of the base, a surface temperature of the base is set to be lower by 5°C or more than a temperature of the solution to be discharged to the surface of the base.

**22.** A method for producing an electronic device comprising a method for producing patterns according to claim 12.

**23.** The method for producing an electronic device according to claim 22,
wherein the second pattern formation material is at least one kind of material selected from the group consisting of a precursor of a metal-oxide dielectric, a semiconductor, metal, and a polymer, and
the electronic device is at least one selected from the group consisting of metal wiring, an electrode, a transistor, a resistor, a capacitor, a microlens, and an imaging device.

**24.** An electronic device comprising a base and patterns formed on a surface of the base,
wherein the patterns include a first pattern region containing organic molecules having fluoroalkyl chains, wherein the organic molecules are at least one selected from the group consisting of: organic molecules containing at least one group selected from a chlorosilyl group, an alkoxy group, and a mercapto group; organic molecules of a straight chain containing a carboxy group or hydroxy group or an amino group; disulfide; silazane; and dithiol; and a second pattern region containing at least one selected from metal, a semiconductor, a metal oxide, and a polymer,
the first pattern region and the second pattern region are stacked in this order on the surface of the base, and
a shape of the first pattern region is similar figure of geometry to a shape of the second pattern region.

**25.** The electronic device according to claim 24, wherein the first pattern region is a monomolecular film of the organic molecules.

**Patentansprüche**

**1.** Austraglösung zur Herstellung von Mustern auf einer Oberfläche eines Trägers, umfassend organische Moleküle mit Fluoralkylketten als erstes musterbildendes Material,
wobei die organischen Moleküle mindestens eine Art sind, ausgewählt aus: organischen Molekülen, die mindestens einen Rest, ausgewählt aus einem Chlorsilylrest, einem Alkoxyrest und einem Mercaptorest, enthalten; geradkettigen organischen Molekülen, die eine Carboxygruppe oder Hydroxygruppe oder eine Aminogruppe enthalten; Disulfiden; Silazanen; und Dithiolen;
wobei die Oberflächenspannung der Lösung 0,02 N/m (20 dyn/cm) oder mehr beträgt.

**2.** Austraglösung nach Anspruch 1, ferner umfassend ein zweites musterbildendes Material.

**3.** Austraglösung nach Anspruch 2, wobei das zweite musterbildende Material mindestens eine Materialart enthält, ausgewählt aus einer Vorstufe eines Metalloxiddielektrikums, einem Halbleiter, Metall und einem Polymer.

**4.** Austraglösung nach Anspruch 3, wobei das zweite musterbildende Material das Metall ist und das Metall ein Metallkolloid ist.

**5.** Austraglösung nach Anspruch 3, wobei das zweite musterbildende Material das Polymer ist und das Polymer mindestens eine Art ist, ausgewählt aus einem leitenden Polymer, einem Halbleiterpolymer, einem isolierenden Polymer und einem lichthärtbaren Polymer.

**6.** Austraglösung nach Anspruch 1, wobei die organischen Moleküle mindestens eine Art sind, ausgewählt aus Molekülen der Zusammensetzungsformel: $CF_3(CF_2)_nC_2H_4Si\{(O\text{-}CH_2CH_2)_m\text{-}OR^1\}_3$ und Hydrolysaten der Moleküle, und in der Zusammensetzungsformel $R^1$ eine Methylgruppe, eine Ethylgruppe, eine Propylgruppe oder eine Butylgruppe ist, und n und m natürliche Zahlen von 1 bis 10 sind.

**7.** Austraglösung nach Anspruch 3, wobei das zweite musterbildende Material die Vorstufe des Metalloxiddielektrikums ist und die Vorstufe des Metalloxiddielektrikums mindestens eines ist, ausgewählt aus Metallalkoxid, Metallacetylacetonat, Metallcarboxylat und einer anorganischen Metallverbindung.

**8.** Austraglösung nach Anspruch 5, wobei das Polymer das Halbleiterpolymer ist und das Halbleiterpolymer mindestens eines ist, ausgewählt aus Polyalkylthiophen und Poly-9,9'-dialkyl-fluoren-co-bithiophen.

**9.** Austraglösung nach Anspruch 1, wobei ein Siedepunkt eines Lösungsmittels, das in der Lösung enthalten ist, 80°C oder höher ist.

**10.** Austraglösung nach Anspruch 1, wobei die Lösung für das Bilden von Mustern auf einer Oberfläche eines Trägers durch ein Tintenstrahlverfahren anwendbar ist.

**11.** Verfahren zur Herstellung von Mustern, umfassend:

Austragen einer Lösung mit einer Oberflächenspannung von 0,02 N/m (20 dyn/cm) oder mehr, in der organische Moleküle mit Fluoralkylketten als erstes musterbildendes Material gelöst sind, auf eine Oberfläche eines Trägers durch ein Tintenstrahlverfahren, um Zeichnen durchzuführen;
wobei die organischen Moleküle mindestens eine Art sind, ausgewählt aus organischen Molekülen, die mindestens einen Rest, ausgewählt aus einem Chlorsilylrest, einem Alkoxyrest und einem Mercaptorest, enthalten; geradkettigen organischen Molekülen, die eine Carboxygruppe oder Hydroxygruppe oder eine Aminogruppe enthalten; Disulfiden; Silazanen; und Dithiolen; und
Verdampfen eines Lösungsmittels, das in der ausgetragenen Lösung enthalten ist, um Muster zu bilden, die die organischen Moleküle enthalten.

**12.** Verfahren zur Herstellung von Mustern nach Anspruch 11, wobei die Lösung ferner ein zweites musterbildendes Material umfasst, wobei das Verfahren Verdampfen eines Lösungsmittels, das in der Austraglösung enthalten ist, um Muster zu bilden, die die organischen Moleküle und das zweite musterbildende Material enthalten, umfasst.

13. Verfahren zur Herstellung von Mustern nach Anspruch 12, umfassend Verdampfen eines Lösungsmittels, das in der Austraglösung enthalten ist, um Muster zu bilden, die eine erste Musterregion, die eine relativ große Menge der organischen Moleküle enthält, und eine zweite Musterregion, die eine relativ große Menge des zweiten musterbildenden Materials enthält, einschließen,
wobei die Muster so gebildet werden, dass die erste Musterregion auf der Trägerseite bezogen auf die zweite Musterregion vorhanden ist.

14. Verfahren zur Herstellung von Mustern nach Anspruch 12, wobei das zweite musterbildende Material mindestens eine Materialart enthält, ausgewählt aus einer Vorstufe eines Metalloxiddielektrikums, einem Halbleiter, Metall und einem Polymer.

15. Verfahren zur Herstellung von Mustern nach Anspruch 14, wobei das zweite musterbildende Material das Metall ist und das Metall ein Metallkolloid ist.

16. Verfahren zur Herstellung von Mustern nach Anspruch 14, wobei das zweite musterbildende Material das Polymer ist und das Polymer mindestens eine Art ist, ausgewählt aus einem leitenden Polymer, einem Halbleiterpolymer, einem isolierenden Polymer und einem lichthärtbaren Polymer.

17. Verfahren zur Herstellung von Mustern nach Anspruch 11, wobei die organischen Moleküle mindestens eine Art sind, ausgewählt aus Molekülen einer Zusammensetzungsformel: $CF_3(CF_2)_nC_2H_4Si\{(O-CH_2CH_2)_m-OR^1\}_3$ und Hydrolysaten der Moleküle, und
in der Zusammensetzungsformel $R^1$ eine Methylgruppe, eine Ethylgruppe, eine Propylgruppe oder eine Butylgruppe ist, und n und m natürliche Zahlen von 1 bis 10 sind.

18. Verfahren zur Herstellung von Mustern nach Anspruch 14, wobei das zweite musterbildende Material die Vorstufe des Metalloxiddielektrikums ist und die Vorstufe des Metalloxiddielektrikums mindestens eines ist, ausgewählt aus Metallalkoxid, Metallacetylacetonat, Metallcarboxylat und einer anorganischen Metallverbindung.

19. Verfahren zur Herstellung von Mustern nach Anspruch 16, wobei das Polymer das Halbleiterpolymer ist und das Halbleiterpolymer mindestens eines ist, ausgewählt aus Polyalkylthiophen und Poly-9,9'-dialkyl-fluoren-co-bithiophen.

20. Verfahren zur Herstellung von Mustern nach Anspruch 11, wobei ein Siedepunkt des Lösungsmittels 80°C oder höher ist.

21. Verfahren zur Herstellung von Mustern nach Anspruch 11, wobei, wenn die Lösung auf die Oberfläche des Trägers ausgetragen wird, eine Oberflächentemperatur des Trägers auf eine um 5°C oder mehr niedrigere Temperatur als eine Temperatur der Lösung, die auf die Oberfläche des Trägers ausgetragen wird, eingestellt wird.

22. Verfahren zur Herstellung eines elektronischen Geräts, umfassend ein Verfahren zur Herstellung von Mustern nach Anspruch 12.

23. Verfahren zur Herstellung eines elektronischen Geräts nach Anspruch 22, wobei das zweite musterbildende Material mindestens eine Materialart ist, ausgewählt aus einer Vorstufe eines Metalloxiddielektrikums, einem Halbleiter, Metall und einem Polymer, und
das elektronische Gerät mindestens eines ist, ausgewählt aus Metallverdrahtung, einer Elektrode, einem Transistor, einem Widerstand, einem Kondensator, einer Mikrolinse und einem Bildaufzeichnungsgerät.

24. Elektronisches Gerät, umfassend einen Träger und Muster, die auf einer Oberfläche des Trägers gebildet sind, wobei die Muster eine erste Musterregion, die organische Moleküle mit Fluoralkylketten enthält, wobei die organischen Moleküle mindestens eine Art sind, ausgewählt aus organischen Molekülen, die mindestens einen Rest, ausgewählt aus einem Chlorsilylrest, einem Alkoxyrest und einem Mercaptorest, enthalten; geradkettigen organischen Molekülen, die eine Carboxygruppe oder Hydroxygruppe oder eine Aminogruppe enthalten; Disulfiden; Silazanen; und Dithiolen; und eine zweite Musterregion, die mindestens eines, ausgewählt aus Metall, einem Halbleiter, einem Metalloxid und einem Polymer, enthält, einschließen,
wobei die erste Musterregion und die zweite Musterregion in dieser Reihenfolge auf der Oberfläche des Trägers geschichtet sind, und

eine Form der ersten Musterregion eine ähnliche geometrische Figur wie eine Form der zweiten Musterregion aufweist.

**25.** Elektronisches Gerät nach Anspruch 24, wobei die erste Musterregion ein monomolekularer Film aus den organischen Molekülen ist.

**Revendications**

**1.** Solution de décharge pour former des motifs sur une surface d'une base, comprenant des molécules organiques ayant des chaînes fluoroalkyle en tant que premier matériau de formation de motifs,

dans laquelle les molécules organiques sont au moins une choisie parmi le groupe consistant en : des molécules organiques contenant au moins un groupement choisi parmi un groupement chlorosilyle, un groupement alkoxy, un groupement mercapto ; des molécules organiques d'une chaîne droite contenant un groupement carboxy ou un groupement hydroxy ou un groupement amino ; un disulfure ; un silazane ; et un dithiol ;

dans laquelle la tension de surface de la solution est 0,02 N/m (20 dyne/cm) ou plus.

**2.** Solution de décharge selon la revendication 1, comprenant en outre un deuxième matériau de formation de motifs.

**3.** Solution de décharge selon la revendication 2,

dans laquelle le deuxième matériau de formation de motifs contient au moins un type de matériau choisi parmi le groupe consistant en un précurseur d'un diélectrique d'oxyde de métal, un semi-conducteur, un métal, et un polymère.

**4.** Solution de décharge selon la revendication 3,

dans laquelle le deuxième matériau de formation de motifs est le métal et le métal est un colloïde de métal.

**5.** Solution de décharge selon la revendication 3,

dans laquelle le deuxième matériau de formation de motifs est le polymère et le polymère est au moins un type choisi dans le groupe consistant en un polymère conducteur, un polymère semi-conducteur, un polymère isolant, et un polymère durcissable à la lumière.

**6.** Solution de décharge selon la revendication 1,

dans laquelle les molécules organiques sont au moins une choisie dans le groupe consistant en les molécules représentées par une formule de composition : $CF_3(CF_2)_nC_2H_4Si\{ (O-CH_2CH_2)_m-OR^1\}_3$, et l'hydrolysat des molécules, et

dans la formule de composition, $R^1$ est un groupement méthyle, un groupement éthyle, un groupement propyle, ou un groupement butyle, et n et m sont des nombres naturels de 1 à 10.

**7.** Solution de décharge selon la revendication 3,

dans laquelle le deuxième matériau de formation de motifs est le précurseur du diélectrique d'oxyde de métal et le précurseur du diélectrique d'oxyde de métal est au moins un choisi parmi le groupe consistant en un alkoxyde de métal, un acétylacétonate de métal, un carboxylate de métal, et un composé inorganique de métal.

**8.** Solution de décharge selon la revendication 5,

dans laquelle le polymère est le polymère semi-conducteur et le polymère semi-conducteur est au moins un choisi parmi le groupe consistant en le polyalkylthiophène et le poly-9,9'dialkyl-fluorène-co-bithiophène.

**9.** Solution de décharge selon la revendication 1,

dans laquelle un point d'ébullition d'un solvant contenu dans la solution est 80°C ou plus.

**10.** Solution de décharge selon la revendication 1,

dans laquelle la solution est applicable pour former des motifs sur une surface d'une base par un procédé à jet d'encre.

**11.** Procédé pour produire des motifs comprenant :

de décharger une solution ayant une tension de surface de 0,02 N/m (20 dyne/cm) ou plus, dans laquelle des molécules organiques ayant des chaînes fluoroalkyle sont dissoutes en tant que premier matériau de formation de motifs, sur une surface d'une base par un procédé à jet d'encre pour effectuer le dessin ; et
dans laquelle les molécules organiques sont au moins une choisie parmi le groupe consistant en : des molécules organiques contenant au moins un groupement choisi parmi un groupement chlorosilyle, un groupement alkoxy, un groupement mercapto ; des molécules organiques d'une chaîne droite contenant un groupement carboxy ou un groupement hydroxy ou un groupement amino ; un disulfure ; un silazane ; et un dithiol ;
de faire évaporer un solvant contenu dans la solution déchargée pour former des motifs contenant les molécules organiques.

**12.** Procédé pour produire des motifs selon la revendication 11, la solution comprenant en outre un deuxième matériau de formation de motifs, le procédé comprenant de faire évaporer un solvant contenu dans la solution déchargée pour former des motifs contenant les molécules organiques et le deuxième matériau de formation de motifs.

**13.** Procédé pour produire des motifs selon la revendication 12, comprenant de faire évaporer un solvant contenu dans la solution déchargée pour former des motifs incluant une première région de motifs contenant une quantité relativement importante des molécules organiques et une deuxième région de motifs contenant une quantité relativement importante du deuxième matériau de formation de motifs
dans lequel les motifs sont formés de telle manière que la première région de motifs est présente sur le côté de base par rapport à la deuxième région de motifs.

**14.** Procédé pour produire des motifs selon la revendication 12, dans lequel le deuxième matériau de formation de motifs contient au moins un type de matériau choisi parmi le groupe consistant en un précurseur d'un diélectrique d'oxyde de métal, un semi-conducteur, un métal, et un polymère.

**15.** Procédé pour produire des motifs selon la revendication 14, dans lequel le deuxième matériau de formation de motifs est le métal et le métal est un colloïde de métal.

**16.** Procédé pour produire des motifs selon la revendication 14, dans lequel le deuxième matériau de formation de motifs est le polymère et le polymère est au moins un type choisi dans le groupe consistant en un polymère conducteur, un polymère semi-conducteur, un polymère isolant, et un polymère durcissable à la lumière.

**17.** Procédé pour produire des motifs selon la revendication 11, dans lequel les molécules organiques sont au moins une choisie dans le groupe consistant en les molécules représentées par une formule de composition : $CF_3$ $(CF_2)_nC_2H_4Si\{(O\text{-}CH_2CH_2)_m\text{-}OR^1\}_3$, et l'hydrolysat des molécules, et
dans la formule de composition, $R^1$ est un groupement méthyle, un groupement éthyle, un groupement propyle, ou un groupement butyle, et n et m sont des nombres naturels de 1 à 10.

**18.** Procédé pour produire des motifs selon la revendication 14, dans lequel le deuxième matériau de formation de motifs est le précurseur du diélectrique d'oxyde de métal et le précurseur du diélectrique d'oxyde de métal est au moins un choisi parmi le groupe consistant en un alkoxyde de métal, un acétylacétonate de métal, un carboxylate de métal, et un composé inorganique de métal.

**19.** Procédé pour produire des motifs selon la revendication 16, dans lequel le polymère est le polymère semi-conducteur et le polymère semi-conducteur est au moins un choisi parmi le groupe consistant en le polyalkylthiophène et le poly-9,9'dialkyl-fluorène-co-bithiophène.

**20.** Procédé pour produire des motifs selon la revendication 11, dans lequel un point d'ébullition du solvant est 80°C ou plus.

**21.** Procédé pour produire des motifs selon la revendication 11, dans lequel lorsque la solution est déchargée sur la surface de la base, une température de surface de la base est fixée de manière à être inférieure de 5°C ou plus à une température de la solution à décharger sur la surface de la base.

**22.** Procédé pour produire un dispositif électronique comprenant un procédé pour produire des motifs selon la revendication 12.

**23.** Procédé pour produire un dispositif électronique selon la revendication 22, dans lequel le deuxième matériau de formation de motifs est au moins un type de matériau choisi parmi le groupe consistant en un précurseur d'un diélectrique d'oxyde de métal, un semi-conducteur, un métal, et un polymère, et

le dispositif électronique est au moins un choisi parmi le groupe consistant en un câblage métallique, une électrode, un transistor, une résistance, un condensateur, une microlentille, et un dispositif d'imagerie.

24. Dispositif électronique comprenant une base et des motifs formés sur une surface de la base, dans lequel les motifs incluent une première région de motifs contenant des molécules organiques ayant des chaînes fluoroalkyle, dans laquelle les molécules organiques sont au moins une choisie parmi le groupe consistant en : des molécules organiques contenant au moins un groupement choisi parmi un groupement chlorosilyle, un groupement alkoxy, un groupement mercapto ; des molécules organiques d'une chaîne droite contenant un groupement carboxy ou un groupement hydroxy ou un groupement amino ; un disulfure ; un silazane ; et un dithiol ; et une deuxième région de motifs contenant au moins un choisi parmi un métal, un semi-conducteur, un oxyde de métal, et un polymère, la première région de motifs et la deuxième région de motifs sont empilées dans cet ordre sur la surface de la base, et une forme de la première région de motifs est une figure de géométrie similaire à une forme de la deuxième région de motifs.

25. Dispositif électronique selon la revendication 24, dans lequel la première région de motifs est un film monomoléculaire des molécules organiques.

FIG. 1A

FIG. 1B

FIG. 1C

FIG. 2A

FIG. 2B

FIG. 3A

FIG. 3B

FIG. 3C

FIG. 4A

FIG. 4B

FIG. 4C

FIG. 5A

FIG. 5B

FIG. 5C

FIG. 6A

FIG. 6B

FIG. 6C

EP 1 614 329 B1

FIG. 7

FIG. 8

FIG. 9A

FIG. 9B

FIG. 9C

FIG. 9D

FIG. 10A

FIG. 10B

FIG. 10C

FIG. 10D

FIG. 11

FIG. 12

52

60

59

57

56

56

58

2

A

B

**FIG. 13A**

57

60

59

56

58

D

**FIG. 13B**

FIG. 14

FIG. 15A

FIG. 15B

FIG. 16

FIG. 17

**FIG. 18A**

**FIG. 18B**

FIG. 19A

FIG. 19B

FIG. 20A

FIG. 20B